# EUROPEAN PATENT APPLICATION

(11) **EP 4 239 654 A1**
(43) Date of publication of application: **06.09.2023**
(21) Application number: 21896271.0
(22) Date of filing: 11.06.2021
(51) Int. Cl.: H01F 27/28, H01F 27/34, H01F 17/06, H03H 7/09

(54) **COMMON-MODE FILTER AND TERMINAL DEVICE**

(30) Priority: 26.11.2020 CN 202011356034
(71) Applicant: Huawei Technologies Co., Ltd., Shenzhen, Guangdong 518129 (CN)
(72) Inventor: CHEN, Kaikai, Shenzhen, Guangdong 518129 (CN); LIU, Chenjun, Shenzhen, Guangdong 518129 (CN); CHENG, Weichang, Shenzhen, Guangdong 518129 (CN); WU, Long, Shenzhen, Guangdong 518129 (CN); DI, Wei, Shenzhen, Guangdong 518129 (CN); ZHOU, Jianjun, Shenzhen, Guangdong 518129 (CN)
(74) Representative: Thun, Clemens
(86) International application number: PCT/CN2021/099641
(87) International publication number: WO 2022/110762

(57) **Abstract**

This application relates to the field of filter technologies, and provides a common mode filter and a terminal device. The common mode filter includes a first winding and a second winding. A portion of the first winding and a portion of the second winding are formed, by rotating around a same axis, at a first coil layer. The other portion of the first winding and the other portion of the second winding are formed, by rotating around another same axis, at a second coil layer stacked with the first coil layer. At the first coil layer and the second coil layer, there is one turn of the second winding between each two adjacent turns of the first winding. At the first coil layer, the first winding and the second winding are disposed in a manner of surrounding from an outer turn to an inner turn, and the second winding is located at the outer turn relative to the first winding. At the second coil layer, the first winding and the second winding are disposed in a manner of surrounding from an inner turn to an outer turn, and the second winding is located at the inner turn relative to the first winding. A surrounding direction of the first winding and the second winding at the second coil layer is the same as a surrounding direction of the first winding and the second winding at the first coil layer.

## Description

This application claims priority to Chinese Patent Application No. 202011356034.6, filed with the China National Intellectual Property Administration on November 26, 2020 and entitled "COMMON MODE FILTER AND TERMINAL DEVICE", which is incorporated herein by reference in its entirety.

### TECHNICAL FIELD

This application relates to the field of filter technologies, and in particular, to a common mode filter and a terminal device.

### BACKGROUND

In mobile communication terminal devices, D-PHY and C-PHY protocols for mobile device industry processor interfaces (Mobile Industry Processoer Interferences, MIPIs) are widely used in the industry as data transmission standards for connecting processors and multimedia devices (such as a display and a camera).

To suppress interference to a high-speed signal transmitted to the display and the camera, these terminal devices further include common mode filters (Common Mode Filters, CMFs). With development of a 5th generation mobile communication technology (5th generation mobile networks, 5G), an antenna with a wider frequency band is introduced. In a 5G high-frequency high-speed application scenario, an overlap between a power spectrum of the high-speed signal and an antenna frequency band become wider. As a noise frequency increases, mode conversion of the common mode filter causes increasing impact. More common mode noise is converted into differential mode noise and superposed on a differential signal. This greatly deteriorates transmission quality of the high-speed signal. For example, the mode conversion of the common mode filter causes superposing, through mode conversion and on the high-speed signal, a current on a high-speed interface of an antenna coupled to structures such as the display and the camera, and generates a large quantity of bit errors. This may cause interference such as erratic display and stripes in modules such as the camera and the display.

In addition, because a conventional common mode filter has a low suppression bandwidth (also referred to as a low suppression center frequency), suppression effect on common mode noise in a 5G high frequency band is poor, and anti-interference effect on each interface circuit in a terminal device in the 5G frequency band is not obvious.

In addition, as a transmission speed increases, an insertion loss caused by the conventional common mode filter on a high-frequency signal increases. This greatly limits link bandwidth improvement and affects high-speed signal quality.

### SUMMARY

This application provides a common mode filter and a terminal device, mainly to provide a common mode filter that can reduce a mode conversion loss, reduce a high-frequency insertion loss, and expand a common mode suppression bandwidth.

The following technical solutions are used in this application.

According to a first aspect, this application provides a common mode filter. The common mode filter includes a first winding and a second winding. A portion of the first winding and a portion of the second winding are formed, by rotating around a same axis, at a first coil layer. The other portion of the first winding and the other portion of the second winding are formed, by rotating around another same axis, at a second coil layer stacked with the first coil layer. At the first coil layer and the second coil layer, there is one turn of the second winding between each two adjacent turns of the first winding. At the first coil layer, the first winding and the second winding are disposed in a manner of surrounding from an outer turn to an inner turn, and the second winding is located at the outer turn relative to the first winding. At the second coil layer, the first winding and the second winding are disposed in a manner of surrounding from an inner turn to an outer turn, and the second winding is located at the inner turn relative to the first winding. A surrounding direction of the first winding and the second winding at the second coil layer is the same as a surrounding direction of the first winding and the second winding at the first coil layer.

According to the common mode filter provided in this application, the first winding and the second winding at each coil layer rotate around the same axis, and two adjacent turns of the first winding are spaced by a turn of the second winding. In this way, at any coil layer, the first winding and the second winding are disposed in a spaced manner along a radial direction of a spiral, to enhance a common mode coupling inductance between the first winding and the second winding, and well balance common mode magnetic coupling between the first winding and the second winding.

In addition, at the first coil layer, the first winding and the second winding are disposed in a manner of surrounding from an outer turn to an inner turn, and the second winding is located at the outer turn relative to the first winding. At the second coil layer, the first winding and the second winding are disposed in a manner of surrounding from an inner turn to an outer turn, the second winding is located at the inner turn relative to the first winding. A surrounding direction of the first winding and the second winding at the second coil layer is the same as a surrounding direction of the first winding and the second winding at the first coil layer. In this way, a sum of lengths of first windings at all coil layers is basically equal to a sum of lengths of second windings at all coil layers. This eliminates a latency difference between signal transmission in the first winding and the second winding, and reduces conversion between differential mode and common mode signals, thereby reducing a mode conversion loss of the common mode filter, reducing a high-frequency insertion loss, and widening a common mode suppression bandwidth.

In a possible implementation of the first aspect, the first winding and the second winding are staggered in an orthogonal direction of a stacking direction of the first coil layer and the second coil layer. When the first winding and the second winding are disposed in the staggered manner in the orthogonal direction of the stacking direction, a parasitic distributed capacitance between two adjacent layers of coils can be reduced, thereby further improving the suppression bandwidth of the common mode filter and reducing the mode conversion loss.

In a possible implementation of the first aspect, at any one of the first coil layer and the second coil layer, each two adjacent turns of the first winding are respectively a first turn of the first winding and a second turn of the first winding. A turn of the second winding located between the first turn of the first winding and the second turn of the first winding is an intermediate turn of the second winding. A spacing between the intermediate turn of the second winding and the first turn of the first winding is smaller than a spacing between the intermediate turn of the second winding and the second turn of the first winding. In this way, a magnetic coupling amount of the intermediate turn of the second winding and the first turn of the first winding is not greatly interfered by the second turn of the first winding, to improve balance of the common mode filter.

In a possible implementation of the first aspect, the first coil layer and the second coil layer are disposed in a dielectric layer, and are spaced by the dielectric layer. A conductive channel consistent with the stacking direction passes through the dielectric layer. The first winding at the first coil layer is electrically connected to the first winding at the second coil layer through the conductive channel. The second winding at the first coil layer is electrically connected to the second winding at the second coil layer through the conductive channel. A portion that is of the second winding at the first coil layer and that is close to the conductive channel intersects, in the orthogonal direction of the stacking direction, with a portion that is of the first winding at the second coil layer and that is close to the conductive channel. In such structure of connecting the first winding and the second winding, on the premise that the sum of the lengths of the first windings at all the coil layers is basically equal to the sum of the lengths of the second windings at all the coil layers, the conductive channel can pass through along the stacking direction, to facilitate processing and manufacturing.

In a possible implementation of the first aspect, the first winding and the second winding each have a connection end extending to an outside of a spiral. The connection end is configured to connect to an inlet terminal or an outlet terminal, and a wire width of the connection end is greater than a wire width of the spiral winding. The greater wire width of the connection end improves characteristic impedances of input and output wires and reduces a return loss of the common mode filter.

In a possible implementation of the first aspect, the common mode filter further includes: a substrate, where the second coil layer is disposed on a surface of the substrate, and the first coil layer is located at the second coil layer; and the inlet terminal and the outlet terminal, both disposed on a side that is of the first coil layer and that is away from the second coil layer.

In a possible implementation of the first aspect, the substrate is made of a non-magnetic material. In this way, the common mode filter may be manufactured by using a semiconductor process, a wire width of a winding is more flexibly designed, impedance control is easy to implement, a dielectric material loss is lower, and the two-wire common mode filter can have a high application bandwidth.

In a possible implementation of the first aspect, the common mode filter further includes: a third coil layer and a fourth coil layer. The first coil layer, the second coil layer, the third coil layer, and the fourth coil layer are sequentially stacked. At the third coil layer and the fourth coil layer, there is one turn of the second winding between each two adjacent turns of the first winding. At the third coil layer, the first winding and the second winding are disposed in a manner of surrounding from an outer turn to an inner turn, and the second winding is located at the outer turn relative to the first winding. At the fourth coil layer, the first winding and the second winding are disposed in a manner of surrounding from an inner turn to an outer turn. A surrounding direction of the first winding and the second winding at the third coil layer is the same as a surrounding direction of the first winding and the second winding at the fourth coil layer. In this way, a two-wire common mode filter with an extremely low high-frequency insertion loss, a higher common mode suppression bandwidth, and an extremely low mode conversion loss can be formed.

In a possible implementation of the first aspect, the common mode filter further includes a first substrate and a second substrate. At least one of the first substrate and the second substrate is made of a magnetic material. The first substrate and the second substrate are disposed opposite to each other, and a coil layer is disposed between the first substrate and the second substrate. At least one of the first substrate and the second substrate is made of a magnetic material, so that a low-frequency interference application scenario can be met without affecting the balance.

According to a second aspect, this application provides a common mode filter. The common mode filter includes: a first winding, a second winding, and a third winding. A portion of the first winding and a portion of the second winding are formed, by rotating around a same axis, at a two-wire coil layer. The other portion of the first winding and the other portion of the second winding are formed, by rotating around another same axis, at another two-wire coil layer. At any two-wire coil layer, there is one turn of the second winding between each two adjacent turns of the first winding. A portion of the third winding is formed at a single-wire coil layer, and the other portion of the third winding is formed at another single-wire coil layer. Between the single-wire coil layer and the two-wire coil layers adjacent to the single-wire coil layer, in an orthogonal direction of a stacking direction, the third winding, the first winding, and the second winding are staggered, and form a plurality of triangular coupling structures independent of each other. Any turn of the first winding or any turn of the second winding belongs to an independent triangular coupling structure.

According to the common mode filter provided in this application, the first winding and the second winding at each two-wire coil layer rotate around the same axis, and two adjacent turns of the first winding are spaced by a turn of the second winding. In this way, at any two-wire coil layer, the first winding and the second winding are disposed in a spaced manner along a radial direction of a spiral, to enhance a common mode coupling inductance between the first winding and the second winding, and well balance common mode magnetic coupling between the first winding and the second winding.

In addition, in the orthogonal direction of the stacking direction, the third winding, the first winding, and the second winding are disposed in the staggered manner, and form the plurality of triangular coupling structures independent of each other. In this way, the first winding, the second winding, and the third winding have consistent impedances and consistent coupling inductances, so that respective differential mode insertion losses formed by the three windings are consistent, and a return loss of the entire common mode filter is small.

In a possible implementation of the second aspect, at any two-wire coil layer, each two adjacent turns of the first winding are respectively a first turn of the first winding and a second turn of the first winding. A turn of the second winding located between the first turn of the first winding and the second turn of the first winding is an intermediate turn of the second winding. A spacing between the intermediate turn of the second winding and the first turn of the first winding is S 1. A spacing between the intermediate turn of the second winding and the second turn of the first winding is S2, where S 1 is smaller than S2. The third winding, the intermediate turn of the second winding, and the first turn of the first winding form an independent triangular coupling structure. In this way, in the orthogonal direction of the stacking direction, adjacent triangular coupling structures may be moved away from each other in a horizontal direction, thereby reducing a characteristic impedance fluctuation and a distributed capacitance, and improving an insertion loss Sdd21, a return loss Sdd11, and balance performance Scd21.

In a possible implementation of the second aspect, in the stacking direction, a spacing between two adjacent triangular coupling structures is d1, and in each triangular coupling structure, a spacing between the two-wire coil layer and the single-wire coil layer that are adjacent to each other is d2, where d2 is greater than d1. In this way, in the stacking direction, the two adjacent triangular coupling structures are moved away and isolated from each other. Similarly, the characteristic impedance fluctuation and the distributed capacitance are reduced, and the insertion loss Sdd21, the return loss Sdd11, and the balance performance Scd21 are improved.

In a possible implementation of the second aspect, the two-wire coil layer and the single-wire coil layer are disposed in a dielectric layer, and are spaced by the dielectric layer. A first conductive channel, a second conductive channel, and a third conductive channel that are consistent with the stacking direction pass through the dielectric layer. First windings in two adjacent two-wire coil layers are electrically connected through the first conductive channel. Second windings in the two adjacent two-wire coil layers are electrically connected through the second conductive channel. Third windings in the two adjacent single-wire coil layers are electrically connected through the third conductive channel. In the orthogonal direction of the stacking direction, the first conductive channel, the second conductive channel, and the third conductive channel are staggered, and form a triangular coupling structure. Forming the triangular coupling structure by using the first conductive channel, the second conductive channel, and the third conductive channel can further improve balance of the common mode filter.

In a possible implementation of the second aspect, one of the two adjacent two-wire coil layers is a first two-wire coil layer, and the other is a second two-wire coil layer. At the first coil layer, the first winding and the second winding are disposed in a manner of surrounding from an outer turn to an inner turn, and the second winding is located at the outer turn relative to the first winding. At the second coil layer, the first winding and the second winding are disposed in a manner of surrounding from an inner turn to an outer turn, and the second winding is located at the inner turn relative to the first winding. A surrounding direction of the first winding and the second winding at the second coil layer is the same as a surrounding direction of the first winding and the second winding at the first coil layer. Therefore, a sum of lengths of first windings at all two-wire coil layers is basically equal to a sum of lengths of second windings at all two-wire coil layers. This eliminates a latency difference between signal transmission in the first winding and the second winding, and does not cause conversion from a differential mode signal to a common mode signal, thereby reducing a mode conversion loss of the common mode filter, reducing a high-frequency insertion loss, and widening a common mode suppression bandwidth.

In a possible implementation of the second aspect, a portion that is of the second winding at the first two-wire coil layer and that is close to the second conductive channel intersects, in the orthogonal direction of the stacking direction, with a portion that is of the first winding at the second two-wire coil layer and that is close to the first conductive channel. In such structure of connecting the first winding and the second winding, on the premise that the sum of the lengths of the first windings at all the two-wire coil layers is basically equal to the sum of the lengths of the second windings at all the two-wire coil layers, the conductive channel can pass through along the stacking direction, to facilitate processing and manufacturing.

In a possible implementation of the second aspect, there are two single-wire coil layers: a first single-wire coil layer and a second single-wire coil layer, and there are two two-wire coil layers: the first two-wire coil layer and the second two-wire coil layer. The three-wire common mode filter formed in this way is of a four-layer structure. Compared with a conventional three-wire common mode filter having more than six layers, the three-wire common mode filter reduces a quantity of wiring layers, thereby implementing a compact design of the entire three-wire common mode filter.

In a possible implementation of the second aspect, the first single-wire coil layer, the first two-wire coil layer, the second two-wire coil layer, and the second single-wire coil layer are sequentially stacked.

In a possible implementation of the second aspect, the first single-wire coil layer, the first two-wire coil layer, the second single-wire coil layer, and the second two-wire coil layer are sequentially stacked.

In a possible implementation of the second aspect, the first two-wire coil layer, the first single-wire coil layer, the second single-wire coil layer, and the second two-wire coil layer are sequentially stacked.

In a possible implementation of the second aspect, the first two-wire coil layer, the first single-wire coil layer, the second two-wire coil layer, and the second single-wire coil layer are sequentially stacked.

In a possible implementation of the second aspect, the first two-wire coil layer, the second two-wire coil layer, the first single-wire coil layer, and the second single-wire coil layer each have a connection end extending to an outside of a spiral. The connection end is configured to connect to an inlet terminal or an outlet terminal, and a wire width of the connection end is greater than a wire width of the spiral winding. The greater wire width of the connection end improves characteristic impedances of input and output wires and reduces a return loss of the common mode filter.

In a possible implementation of the second aspect, the common mode filter further includes: a substrate, where the substrate has a first surface and a second surface that are opposite to each other, the substrate has a conductive channel that passes through from the first surface to the second surface, the first single-wire coil layer and the first two-wire coil layer are disposed on the first surface, and the second single-wire coil layer and the second two-wire coil layer are disposed on the second surface; and the inlet terminal and the outlet terminal, respectively disposed on surfaces that are of the first single-wire coil layer and the first two-wire coil layer and that are away from the substrate. The first single-wire coil layer and the first two-wire coil layer are disposed on the first surface of the substrate, and the second single-wire coil layer and the second two-wire coil layer are disposed on the second surface of the substrate. In this way, a plurality of triangular coupling structures can be isolated and moved away from each other in the stacking direction by using the substrate.

In a possible implementation of the second aspect, the substrate is made of a non-magnetic material. In this way, the common mode filter may be manufactured by using a semiconductor process, a wire width of a winding is more flexibly designed, impedance control is easy to implement, a dielectric material loss is lower, and the two-wire common mode filter can have a high application bandwidth.

In a possible implementation of the second aspect, the common mode filter further includes a first substrate and a second substrate. At least one of the first substrate and the second substrate is made of a magnetic material. The first substrate and the second substrate are disposed opposite to each other, and the two-wire coil layers and the single-wire coil layers each are disposed between the first substrate and the second substrate. At least one of the first substrate and the second substrate is made of a magnetic material, so that a low-frequency interference application scenario can be met without affecting the balance.

According to a third aspect, this application further provides a terminal device, including a printed circuit board and the common mode filter according to any one of the implementations of the first aspect. The common mode filter is electrically connected to the printed circuit board.

The terminal device provided in this embodiment of this application includes the common mode filter in the embodiment of the first aspect. Therefore, the terminal device provided in this embodiment of this application and the common mode filter in the foregoing technical solution can resolve a same technical problem, and achieve same expected effect.

### BRIEF DESCRIPTION OF DRAWINGS

FIG. 1 is a schematic diagram of a part of a structure of a terminal device according to an embodiment of this application;
FIG. 2 is a sectional view of a two-wire common mode filter according to an embodiment of this application;
FIG. 3 is a schematic diagram of wiring of two adjacent coil layers of a two-wire common mode filter according to an embodiment of this application;
FIG. 4 is a three-dimensional schematic diagram of a connection relationship between two adjacent coil layers according to an embodiment of this application;
FIG. 5 is a two-dimensional schematic diagram of a connection relationship between two adjacent coil layers according to an embodiment of this application;
FIG. 6 is a sectional view of another two-wire common mode filter according to an embodiment of this application;
FIG. 7 is a schematic diagram of wiring of each coil layer in FIG. 6;
FIG. 8 is a top view of FIG. 6;
FIG. 9 is an A-A sectional view of FIG. 8;
FIG. 10 is a sectional view of still another two-wire common mode filter according to an embodiment of this application;
FIG. 11 is a sectional view of yet another two-wire common mode filter according to an embodiment of this application;
FIG. 12 is a sectional view of still yet another two-wire common mode filter according to an embodiment of this application;
FIG. 13a is a curve diagram of a differential mode insertion loss Sdd21 in FIG. 12;
FIG. 13b is a curve diagram of a common mode insertion loss Scc21 in FIG. 12;
FIG. 13c is a curve diagram of a mode conversion loss Scd21 in FIG. 12;
FIG. 13d is a curve diagram of a return loss Sdd11 in FIG. 12;
FIG. 14 is a schematic diagram of a corresponding structure after each step in a method for manufacturing a two-wire common mode filter is completed according to an embodiment of this application;
FIG. 15 is a sectional view of a further two-wire common mode filter according to an embodiment of this application;
FIG. 16a is a curve diagram of comparison between a differential mode insertion loss Sdd21 in FIG. 15 and the conventional technology;
FIG. 16b is a curve diagram of comparison between a common mode insertion loss Scc21 in FIG. 15 and the conventional technology;
FIG. 16c is a curve diagram of comparison between a mode conversion loss Scd21 in FIG. 15 and the conventional technology;
FIG. 16d is a curve diagram of comparison between a return loss Sdd11 in FIG. 15 and the conventional technology;
FIG. 17 is a schematic diagram of a corresponding structure after each step in a method for manufacturing a two-wire common mode filter is completed according to an embodiment of this application;
FIG. 18 is a sectional view of a three-wire common mode filter according to an embodiment of this application;
FIG. 19 is a schematic diagram of wiring of each coil layer of a three-wire common mode filter according to an embodiment of this application;
FIG. 20 is a schematic diagram of wiring of each coil layer of a three-wire common mode filter according to an embodiment of this application;
FIG. 21 is a two-dimensional schematic diagram of a connection relationship between adjacent coil layers according to an embodiment of this application;
FIG. 22 is a sectional view of another three-wire common mode filter according to an embodiment of this application;
FIG. 23 is a sectional view of still another three-wire common mode filter according to an embodiment of this application;
FIG. 24 is a sectional view of yet another three-wire common mode filter according to an embodiment of this application;
FIG. 25 is a sectional view of still yet another three-wire common mode filter according to an embodiment of this application;
FIG. 26 is a partial sectional view of a three-wire common mode filter in the conventional technology;
FIG. 27 is a schematic diagram of a structure of a triangular coupling structure in a three-wire common mode filter according to an embodiment of this application;
FIG. 28 is a sectional view of a further three-wire common mode filter according to an embodiment of this application;
FIG. 29 is a sectional view of still further three-wire common mode filter according to an embodiment of this application;
FIG. 30 is a three-dimensional diagram of another three-wire common mode filter according to an embodiment of this application;
FIG. 31a is a curve diagram of comparison between a differential mode insertion loss Sdd21 in FIG. 29 and the conventional technology;
FIG. 31b is a curve diagram of comparison between a common mode insertion loss Scc21 in FIG. 29 and the conventional technology;
FIG. 31c is a curve diagram of comparison between a mode conversion loss Scd21 in FIG. 29 and the conventional technology;
FIG. 31d is a curve diagram of comparison between a return loss Sdd11 in FIG. 29 and the conventional technology;
FIG. 32 is a schematic diagram of a corresponding structure after each step in a method for manufacturing a three-wire common mode filter is completed according to an embodiment of this application;
FIG. 33 is a three-dimensional diagram of still another three-wire common mode filter according to an embodiment of this application;
FIG. 34 is a sectional view of yet further three-wire common mode filter according to an embodiment of this application; and
FIG. 35 is a schematic diagram of a corresponding structure after each step in a method for manufacturing a three-wire common mode filter is completed according to an embodiment of this application.

### Reference numerals:

01-PCB; 02-electrical connection structure; 03-common mode filter;
1-first winding; 101-first turn of the first winding; 102-second turn of the first winding; 2-second winding; 201-first turn of the second winding; 202-second turn of the second winding; 3-third winding; 4-dielectric layer; 5-conductive channel; 51-first conductive channel; 52-second conductive channel; 53-third conductive channel; 6-connection end; 7-inlet terminal; 71-first inlet terminal; 72-second inlet terminal; 73-third inlet terminal; 8-outlet terminal; 81-first outlet terminal; 82-second outlet terminal; 83-third outlet terminal; 9-substrate; 91-first substrate; 92-second substrate; 10-support plate; 11-triangular coupling structure; 111-first triangular coupling structure; 112-second triangular coupling structure; 113-third triangular coupling structure;
L1-first coil layer; L2-second coil layer; L3-third coil layer; L4-fourth coil layer;
L21-first two-wire coil layer; L22-second two-wire coil layer; L31-first single-wire coil layer; and L32-second single-wire coil layer.

### DESCRIPTION OF EMBODIMENTS

To facilitate understanding of technical solutions, the following explains technical terms in this application.

A differential mode insertion loss S parameter is an important parameter in signal transmission. Sij indicates energy injected from a port j and measured at a port i. The differential mode insertion loss parameter is also referred to as an Sdd21 parameter, and represents a ratio of energy of a differential mode signal output from a port 2 to energy of a differential mode signal input from a port 1. An Sdd21 value closer to 0 dB is preferred.

A common mode insertion loss S parameter is also referred to as an Scc21 parameter, and represents a ratio of common mode noise energy from a port 2 to common mode noise energy from a port 1. A smaller value of Scc21 indicates a stronger common mode noise suppression capability, and a wider frequency band indicates a larger suppression bandwidth.

A mode conversion loss S parameter is also referred to an Scd21 parameter, and represents how much energy of a differential mode signal input from a port 1 is converted into common mode noise energy output from a port 2. Smaller Scd21 indicates better balance of a filter and a lower mode loss.

A return loss S parameter is also referred to as an Sdd11 parameter, and represents how much energy of a differential mode signal input from a port 1 is reflected back to the port 1. A smaller Sdd11 value is preferred.

The following describes the technical solutions in embodiments in this application in detail with reference to accompanying drawings.

An embodiment of this application provides a terminal device. The terminal device may include devices such as a mobile phone (mobile phone), a tablet computer (pad), an intelligent wearable product (for example, a smart watch or a smart band), a virtual reality (virtual reality, VR) device, and an augmented reality (augmented reality, AR) device. A specific form of the terminal device is not specially limited in embodiments of this application.

These terminal devices generally include a camera module, a display module, or the like, and also include an antenna. To suppress interference caused by an antenna signal to a signal transmitted from a processor to the camera module or the display module, the terminal device further includes a common mode filter. The common mode filter is configured to suppress common mode noise and transmit a differential data signal.

With development of a 5th generation mobile communication technology (5th generation wireless systems, 5G), antennas in these terminal devices also cover a 5G frequency band. In this case, performance of the common mode filter needs to be further optimized. For example, an extremely low mode conversion loss, a higher common mode suppression bandwidth, and an extremely low high-frequency insertion loss are required. In a 5G high-frequency high-speed application scenario of these terminal devices, this can prevent a current of an antenna coupled to a high-speed interface from being superposed on a high-speed signal through mode conversion, leading to erratic display and stripes in a camera and a display.

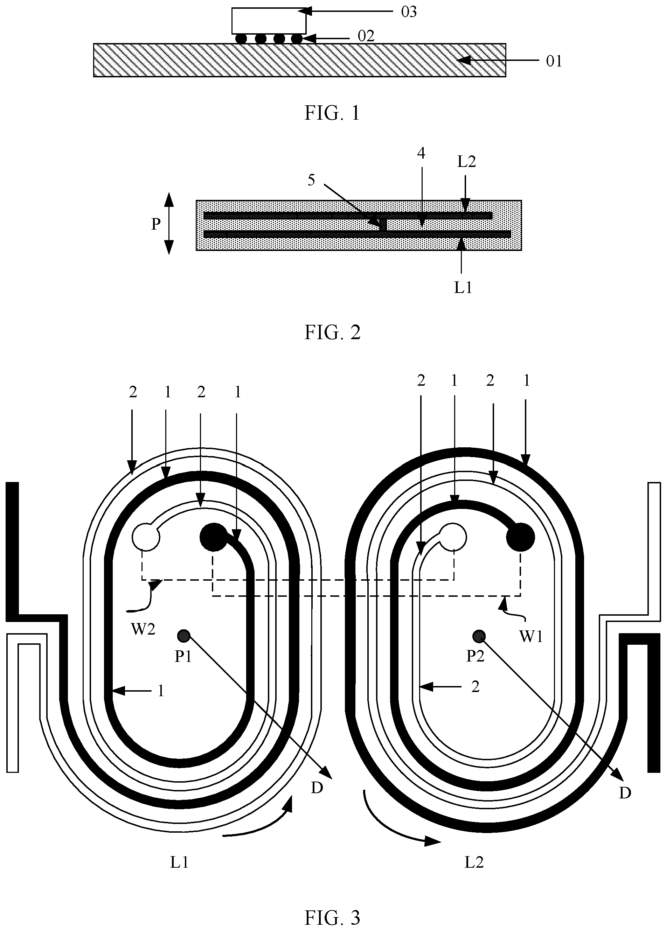

FIG. 1 is a diagram of a part of a structure of the foregoing terminal devices. The terminal device includes a printed circuit board (printed circuit board, PCB) 01 and a common mode filter 03. The common mode filter 03 is integrated on the PCB 01, and is electrically connected to the PCB 01 through an electrical connection structure 02. For example, a differential signal line is disposed on the PCB 01, and the common mode filter 03 is electrically connected to the differential signal line through the electrical connection structure 02.

In the terminal device, D-PHY and C-PHY protocols are usually used as data transmission standards. In the D-PHY protocol standard, signals are transmitted through two differential lines. In the C-PHY protocol standard, different levels are transmitted through three wires at a transmitting end, and differential output is performed at a receiving end.

In other words, in the D-PHY protocol standard, a two-wire common mode filter is used, that is, there are two windings. In the C-PHY protocol standard, a three-wire common mode filter is used, that is, there are three windings.

Therefore, this application provides two common mode filters: the two-wire common mode filter and the three-wire common mode filter. The following describes the two-wire common mode filter and the three-wire common mode filter in detail.

The following describes a structure of the two-wire common mode filter in detail.

FIG. 2 and FIG. 3 are diagrams of a structure of a two-wire common mode filter. The common mode filter includes: a first winding 1 and a second winding 2. A portion of the first winding 1 and a portion of the second winding 2 are formed, by rotating around a same axis (an axis P1 shown in FIG. 3), at a first coil layer L1. The other portion of the first winding 1 and the other portion of the second winding 2 are formed, by rotating around another same axis (an axis P2 shown in FIG. 3), at a second coil layer L2 stacked with the first coil layer L1. The first coil layer L1 and the second coil layer L2 are stacked along a P direction in FIG. 2, and the first coil layer L1 and the second coil layer L2 are spaced by a dielectric layer 4.

To implement electrical connection between two adjacent coil layers, a conductive channel 5 passes through the dielectric layer 4, and the conductive channel 5 is electrically connected to windings having a same name at the first coil layer and the second coil layer. In other words, the first winding at the first coil layer is electrically connected to the first winding at the second coil layer through the conductive channel, and the second winding at the first coil layer is also electrically connected to the second winding at the second coil layer through the conductive channel.

FIG. 3 shows a wiring structure of the first coil layer L1 and the second coil layer L2 in FIG. 2. At the first coil layer L1 and the second coil layer L2, there is one turn of the second winding 2 between two adjacent turns of the first winding 1.

The first winding 1 at the first coil layer L1 is electrically connected (as shown by a dashed line W1 in FIG. 3) to the first winding 1 at the second coil layer L2, and the second winding 2 at the first coil layer L1 is electrically connected (as shown by a dashed line W2 in FIG. 3) to the second winding 2 at the second coil layer L2.

In this way, at any one of the first coil layer L1 and the second coil layer L2, along a radial direction (a D direction shown in FIG. 3) of a spiral, the first winding 1 and the second winding 2 are disposed in a spaced manner. Therefore, at each coil layer, a common mode coupling inductance between the first winding 1 and the second winding 2 can be enhanced, to improve common mode suppression. When a differential signal passes through each coil layer, magnetic fluxes generated by inverting differential mode currents in the first winding and the second winding cancel each other out, thereby reducing a transmission loss of the differential signal and improving quality of the differential signal.

A difference between wiring at the first coil layer L1 and wiring at the second coil layer L2 is as follows: Refer to FIG. 3. At the first coil layer L1, from an inner turn to an outer turn, the first winding 1 is located at the inner turn relative to the second winding 2, that is, the first winding 1 is at the inner turn close to the axis P1. However, at the second coil layer L2, from an inner turn to an outer turn, the second winding 2 is located at the inner turn relative to the first winding 1, that is, the second winding 2 is at the inner turn close to the axis P2.

In this way, when a quantity of turns at the first coil layer L1 is the same as a quantity of turns at the second coil layer L2, a sum of lengths of the first winding 1 at the two coil layers is basically equal to a sum of lengths of the second winding 2. After the differential signal is transmitted through the first coil layer L1 and the second coil layer L2, a latency difference of signal transmission is eliminated, and conversion between differential mode and common mode signals is reduced, thereby reducing Scd21 and improving balance of the common mode filter.

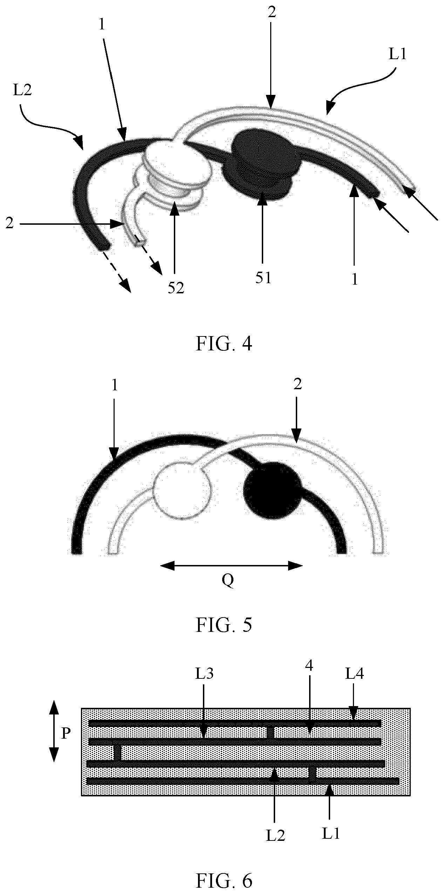

As shown in FIG. 3, first windings and second windings at two adjacent coil layers need to be separately electrically connected through the conductive channel. The wiring structure shown in FIG. 3 is as follows: At the first coil layer L1, from the outer turn to the inner turn, the first winding 1 and the second winding 2 are disposed in a manner of surrounding counterclockwise (counterclockwise). At the second coil layer L2, from the inner turn to the outer turn, the first winding 1 and the second winding 2 are also disposed in a manner of surrounding counterclockwise (counterclockwise). FIG. 4 is a diagram of a connection structure of the first winding 1 and a connection structure of the second winding 2 between the first coil layer L1 and the second coil layer L2 shown in FIG. 3.

Refer to FIG. 4. A first conductive channel 51 that passes through the dielectric layer is electrically connected to the first windings 1 at the two adjacent coil layers, and a second conductive channel 52 that passes through the dielectric layer is electrically connected to the second windings 2 at the two adjacent coil layers. In addition, a portion that is of the second winding 2 at the first coil layer L1 and that is close to the second conductive channel 52 intersects, in an orthogonal direction (a Q direction shown in FIG. 5) of a stacking direction, with a portion that is of the first winding 1 at the second coil layer L2 and that is close to the first conductive channel 51. When windings are electrically connected through such inter-layer cross structure, as shown in FIG. 4, both the first conductive channel 51 and the second conductive channel 52 pass through along a direction parallel to the stacking direction.

FIG. 6 is a sectional view of another two-wire common mode filter, including four coil layers: a first coil layer L1, a second coil layer L2, a third coil layer L3, and a fourth coil layer L4. The first coil layer L1, the second coil layer L2, the third coil layer L3, and the fourth coil layer L4 are sequentially stacked along a stacking direction P.

FIG. 6 is merely an embodiment of the two-wire common mode filter, and may alternatively include more coil layers. In conclusion, in the two-wire common mode filter, there are N coil layers, and N is an even number greater than or equal to 2.

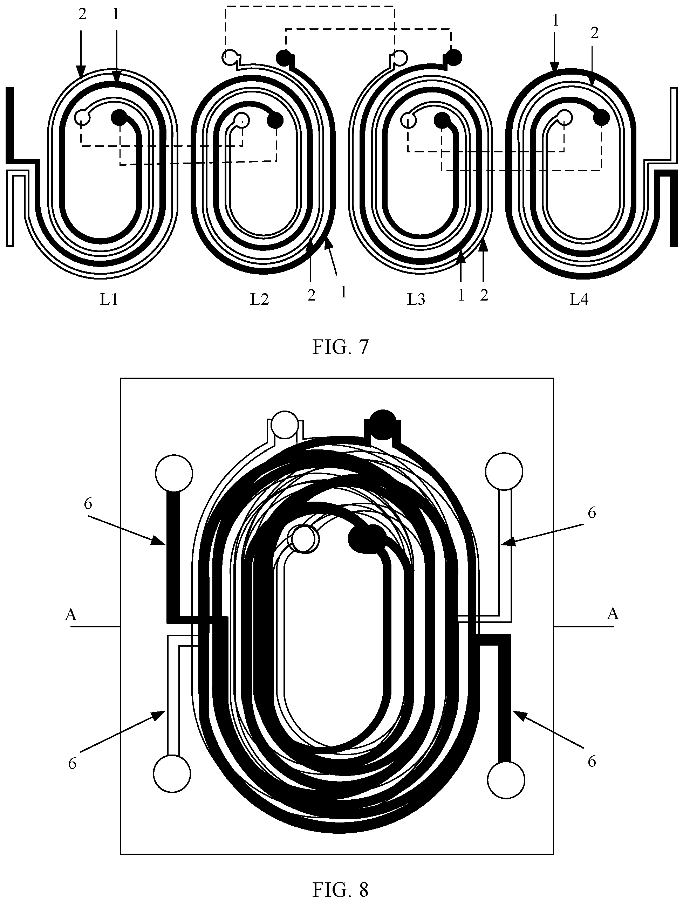

FIG. 7 shows a wiring structure of each coil layer in FIG. 6. A winding manner of the first coil layer L1 and the second coil layer L2 is the same as that shown in FIG. 3, a winding manner of the third coil layer L3 is the same as that of the first coil layer L1, and a winding manner of the fourth coil layer L4 is the same as that of the second coil layer L2.

In addition, a first winding 1 at the first coil layer L1 is electrically connected (as shown by a dashed line in FIG. 7) to a first winding 1 at the second coil layer L2, and a second winding 2 at the first coil layer L1 is electrically connected (as shown by a dashed line in FIG. 7) to a second winding 2 at the second coil layer L2, to implement an electrical connection between the first coil layer L1 and the second coil layer L2.

A first winding 1 at the second coil layer L2 is electrically connected (as shown by a dashed line in FIG. 7) to a first winding 1 at the third coil layer L3, and a second winding 2 at the second coil layer L2 is electrically connected (as shown by a dashed line in FIG. 7) to a second winding 2 at the third coil layer L3, to implement an electrical connection between the second coil layer L2 and the third coil layer L3.

A first winding 1 at the third coil layer L3 is electrically connected (as shown by a dashed line in FIG. 7) to a first winding 1 at the fourth coil layer L4, and a second winding 2 at the third coil layer L3 is electrically connected (as shown by a dashed line in FIG. 7) to a second winding 2 at the fourth coil layer L4, to implement an electrical connection between the third coil layer L3 and the fourth coil layer L4.

In FIG. 7, between two adjacent coil layers, connection of the first windings and connection of the second windings are also electrically connected through the structure shown in FIG. 4 and FIG. 5. A specific connection structure is not described in detail herein.

In the two-wire common mode filter shown in FIG. 7, because both the first winding 1 and the second winding 2 are disposed at each coil layer in a manner of surrounding and along a radial direction of a spiral, the first winding 1 and the second winding 2 are spaced, to enhance common mode magnetic field coupling between the first winding and the second winding at each coil layer, improve a common mode inductance, and improve common mode suppression.

In addition, between two adjacent coil layers, the first winding and the second winding are crossed and exchanged. For example, at the first coil layer L1, the first winding 1 is at an inner side, and the second winding 1 is at an outer side; at the second coil layer L2, the first winding 1 is at an outer side, and the second winding 1 is at an inner side; at the third coil layer L3, the first winding 1 is at an inner side, and the second winding 1 is at an outer side; and at the fourth coil layer L4, the first winding 1 is at an outer side, and the second winding 1 is at an inner side. This can greatly reduce a mode conversion loss of a signal, and basically achieve a zero latency difference.

It should be noted that a structure of the spiral approximating an ellipse formed at each coil layer in FIG. 7 is merely an embodiment, and may alternatively be a rectangular spiral, a circular spiral, or the like.

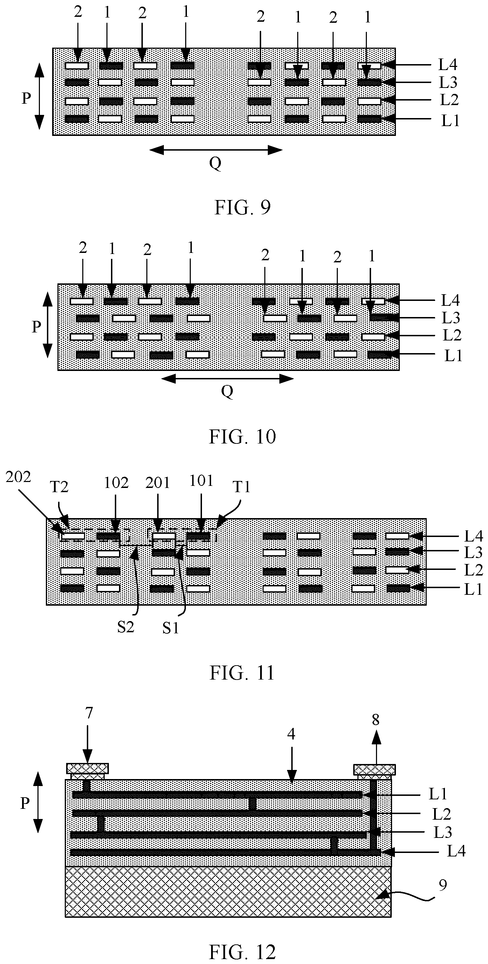

FIG. 8 is a diagram of a structure of the first coil layer L1, the second coil layer L2, the third coil layer L3, and the fourth coil layer L4 that are projected on an orthogonal plane of the stacking direction P in FIG. 7. FIG. 9 is an A-A sectional view of FIG. 8. In FIG. 9, on an orthogonal direction Q of the stacking direction P, a first winding 1 and a second winding 2 between each two adjacent coil layers are disposed oppositely.

In FIG. 9, there is a large distributed capacitance between two adjacent coil layers. To reduce the distributed capacitance, reduce a loss, and increase a common mode suppression bandwidth, so as to further improve balance, this application further provides a two-wire common mode filter. As shown in FIG. 10, in the two-wire common mode filter, on an orthogonal direction Q of the stacking direction P, the first winding 1 and the second winding 2 are staggered. It may also be understood that disposing adjacent coil layers in the staggered manner can greatly reduce a parasitic distributed capacitance between two layers, and further improve a common mode suppression bandwidth and mode conversion performance of the common mode filter.

Refer to FIG. 8. When there are a plurality of coil layers, the first winding and the second winding each have a connection end 6 extending to an outside of a spiral. The connection end 6 is configured to connect to an inlet terminal or an outlet terminal. Because a winding manner of a top coil layer is different from that of a bottom coil layer, as shown in FIG. 7, at the first coil layer L1, the first winding 1 and the second winding 2 are disposed in a manner of surrounding clockwise from an inner turn to an outer turn. At the second coil layer L2, the first winding 1 and the second winding 2 are disposed in a manner of surrounding counterclockwise from an inner turn to an outer turn. In this way, the connection end 6 connected to the first winding 1 and the connection end 6 connected to the second winding 2 extend in opposite directions, and are not spiral windings. The first winding and the second winding are disposed in a manner of surrounding in parallel around an axis. In this way, there is a high impedance between the two connection ends 6. Refer to FIG. 8. To reduce the impedance, mitigate a sudden impedance change caused by no coupling, and reduce a return loss, the connection end may be widened, that is, a wire width of the connection end 6 is greater than a wire width of the spiral winding.

Refer to FIG. 11. To further improve the balance of the two-wire common mode filter, at any coil layer, each two adjacent turns of the first winding are respectively a first turn 101 of the first winding and a second turn 102 of the first winding. A turn of the second winding located between the first turn 101 of the first winding and the second turn 102 of the first winding is an intermediate turn 201 of the second winding. A spacing S 1 between the intermediate turn 201 of the second winding and the first turn 101 of the first winding is smaller than a spacing S2 between the intermediate turn 201 of the second winding and the second turn 102 of the first winding. In this way, the intermediate turn 201 of the second winding and the first turn 101 of the first winding form an independent coupling structure T1. Another turn 202 of the second winding and the second turn 102 of the first winding form another independent coupling structure T2. Magnetic coupling impact between the coupling structure T1 and the coupling structure T2 is small, thereby further improving the mode conversion performance and the balance.

FIG. 12 shows a two-wire common mode filter including a substrate 9. The common mode filter includes the substrate 9. A plurality of coil layers are disposed on a same surface of the substrate 9, and are stacked along a stacking direction P. In this way, an inlet terminal 7 and an outlet terminal 8 are disposed on a surface that is of the plurality of coil layers and that is away from the substrate 9.

The inlet terminal 7 includes a first inlet terminal electrically connected to a first winding 1 and a second inlet terminal electrically connected to a second winding.

The outlet terminal 8 includes a first outlet terminal electrically connected to the first winding 1 and a second outlet terminal electrically connected to the second winding.

Generally, the first inlet terminal and the second inlet terminal are electrically connected to the first winding and the second winding corresponding to a coil layer located at a top through a conductive channel. The first outlet terminal and the second outlet terminal are electrically connected to the first winding and the second winding corresponding to a coil layer located at a bottom through another conductive channel. For example, as shown in FIG. 12, a first coil layer L1, a second coil layer L2, a third coil layer L3, and a fourth coil layer L4 are sequentially stacked along a direction to the substrate 9. In this way, the first inlet terminal and the second inlet terminal are electrically connected to the first winding and the second winding corresponding to the first coil layer L1 through the conductive channel, and the first outlet terminal and the second outlet terminal are electrically connected to the first winding and the second winding corresponding to the fourth coil layer L4 through the another conductive channel.

In the structure shown in FIG. 12, the substrate 9 may be made of a magnetic material, or may be made of a non-magnetic material, such as silicon, glass, resin, ceramic, or ferrite.

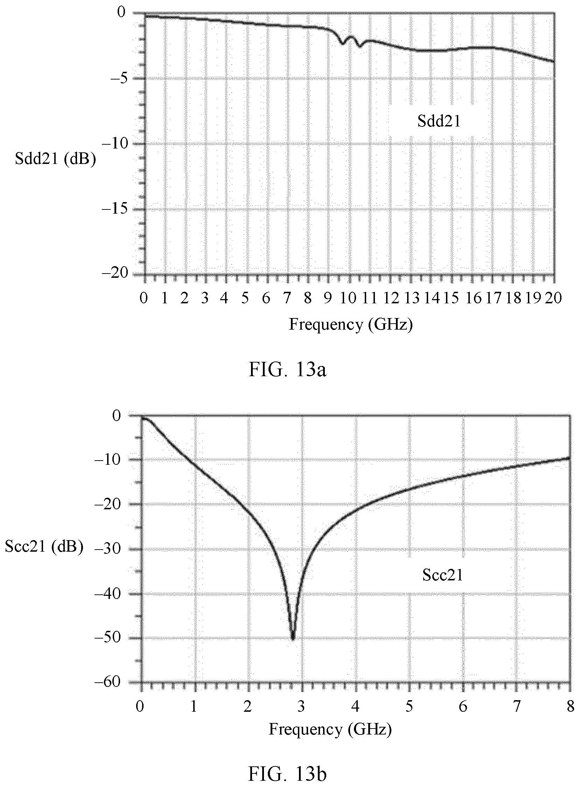

When the substrate 9 in the structure in FIG. 12 is a non-magnetic substrate, FIG. 13a to FIG. 13d are performance simulation of the two-wire common mode filter.

FIG. 13a is a curve diagram of a differential mode insertion loss Sdd21 of the common mode filter. It can be seen from the curve that when a differential mode insertion loss Sdd21 of the two-wire common mode filter is higher than -4 dB, a corresponding bandwidth reaches 20 GHz.

FIG. 13b is a curve diagram of a common mode insertion loss Scc21 of the common mode filter. It can be seen from the curve that when Scc21 of the two-wire common mode filter is smaller than -15 dB, a corresponding common mode suppression bandwidth is from 1.5 GHz to 6 GHz, that is, a total of more than 5 GHz.

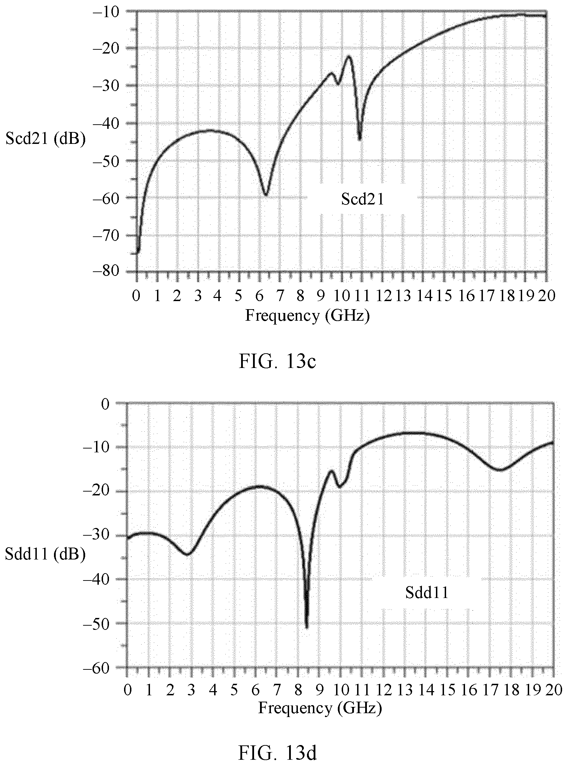

FIG. 13c is a curve diagram of a mode conversion loss Scd21 of the common mode filter. It can be seen from the curve that the two-wire common mode filter has an Scd21 less than -40 dB within 8 GHz. This can effectively suppress noise of a 5G interference frequency band and minimize impact on signal transmission.

FIG. 13d is a curve diagram of a return loss Sdd11 of the common mode filter. It can be seen from the curve that the return loss Sdd11 is less than -20 dB within 8 GHz.

When the substrate 9 is made of a non-magnetic material such as silicon or glass, the two-wire common mode filter may be manufactured by using a conventional semiconductor process. The following describes in detail a method for manufacturing a two-wire common mode filter by using the semiconductor process.

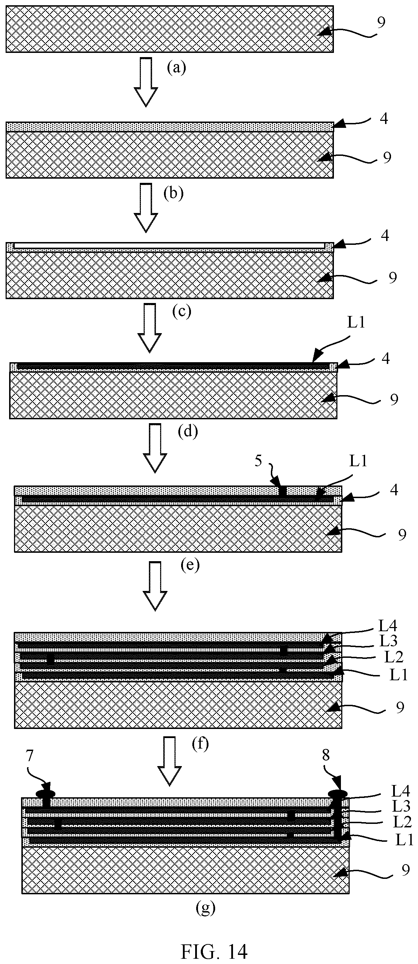

As shown in FIG. 14, the method for manufacturing a common mode filter includes the following steps:

As shown in (a) and (b) in FIG. 14, a dielectric layer 4 is formed on a surface of a substrate 9 made of a non-magnetic material.

As shown in (c) in FIG. 14, the dielectric layer 4 is patterned, to form a pattern layer on the substrate 9.

As shown in (d) in FIG. 14, a first winding and a second winding are disposed on the substrate formed with the pattern layer, and the first winding and the second winding rotate around a same axis to form a spiral first coil layer L1. At the first coil layer L1, from an inner turn to an outer turn, the first winding is located at the inner turn relative to the second winding.

In addition, when the first coil layer L1 is formed, the first winding and the second winding are disposed in a manner of surrounding counterclockwise from outside to inside.

As shown in (e) in FIG. 14, another dielectric layer 4 is formed above the first coil layer L1, and a conductive channel 5 is formed at the another dielectric layer 4.

According to the method in (b), (c), and (d) in FIG. 14, as shown in (f) in FIG. 14, a second coil layer L2, a third coil layer L3, and a fourth coil layer L4 are sequentially formed.

At the second coil layer L2, from an inner turn to an outer turn, the second winding is located at the inner turn relative to the first winding.

At the third coil layer L3, from an inner turn to an outer turn, the first winding is located at the inner turn relative to the second winding.

At the fourth coil layer L4, from an inner turn to an outer turn, the second winding is located at the inner turn relative to the first winding.

When the second coil layer L2 is formed, the first winding and the second winding are disposed in a manner of surrounding counterclockwise from inside to outside.

When the third coil layer L3 is formed, the first winding and the second winding are disposed in a manner of surrounding counterclockwise from outside to inside.

When the fourth coil layer L4 is formed, the first winding and the second winding are disposed in a manner of surrounding counterclockwise from inside to outside.

As shown in (g) in FIG. 14, an inlet terminal 7 and an outlet terminal 8 are formed. The inlet terminal 7 is electrically connected to the first winding and the second winding at the fourth coil layer L4, and the outlet terminal 8 is electrically connected to the first winding and the second winding at the first coil layer L1.

When a two-wire common mode filter is manufactured by using a semiconductor process, a wire width of a winding is more flexibly designed, impedance control is easy to implement, a dielectric material loss is lower, and the two-wire common mode filter can have a high application bandwidth.

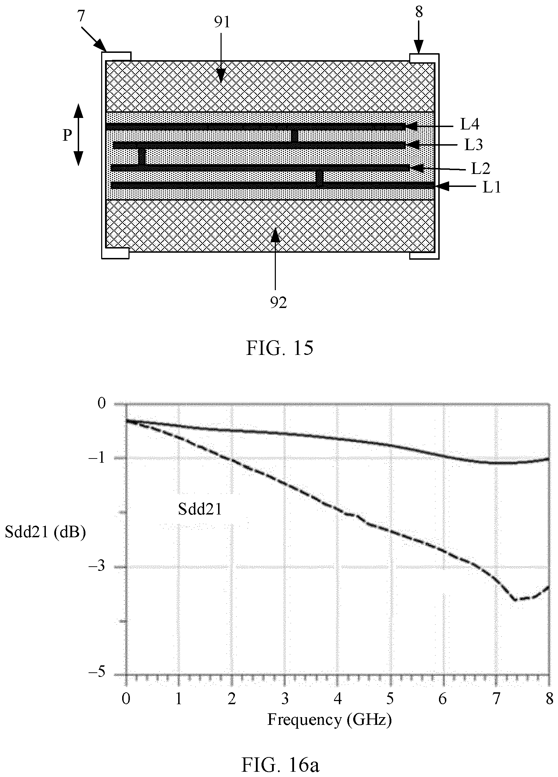

FIG. 15 shows another two-wire common mode filter including a substrate. The common mode filter includes a first substrate 91 and a second substrate 92. The first substrate 91 and the second substrate 92 are disposed opposite to each other, and a plurality of coil layers are stacked between the first substrate 91 and the second substrate 92 along a stacking direction P. An inlet terminal 7 and an outlet terminal 8 are located on two sides of the common mode filter. In addition, the inlet terminal 7 is electrically connected to the first winding and the second winding at the fourth coil layer L4, and the outlet terminal 8 is electrically connected to the first winding and the second winding at the first coil layer L1.

In the two-wire common mode filter shown in FIG. 15, the first substrate 91 and the second substrate 92 each are made of a non-magnetic material. Alternatively, one of the first substrate 91 and the second substrate 92 is made of a non-magnetic material. Alternatively, the first substrate 91 and the second substrate 92 each are made of a magnetic material.

When the first substrate 91 and the second substrate 92 each are made of the non-magnetic material as shown in FIG. 15, or when the substrate 9 in the two-wire common mode filter manufactured in FIG. 14 is also made of a non-magnetic material, and a differential mode insertion loss Sdd21 of the common mode filter is 3 dB, a corresponding bandwidth reaches 20 GHz. Therefore, superior high-frequency performance of the common mode filter makes the common mode filter more suitable for an ultra-high-speed application scenario, for example, all 5G ultra-high-speed scenarios that use two-wire differential interface standards and have a transmission rate of 16 Gbps or higher. A specific product includes a camera (Camera), a mobile phone liquid crystal display (LCD), a PAD LCD, a PC LCD, and a high-definition multimedia interface (HDMI).

To meet some low-frequency application scenarios, at least one of the first substrate 91 and the second substrate 92 in FIG. 15 may be made of a magnetic material. This can enhance magnetic field coupling between windings without changing balance, improve a common mode inductance, and reduce a common mode suppression frequency.

When at least one of the two substrates in the structure in FIG. 15 is a magnetic substrate, FIG. 16a to FIG. 16d are performance simulation of the two-wire common mode filter.

As shown in FIG. 16a, a black solid line is a curve of a differential mode insertion loss Sdd21 of the common mode filter, and a dashed line is a curve of a differential mode insertion loss Sdd21 in the conventional technology. It can be seen from the two curves that the differential mode insertion loss Sdd21 of the two-wire common mode filter is obviously reduced.

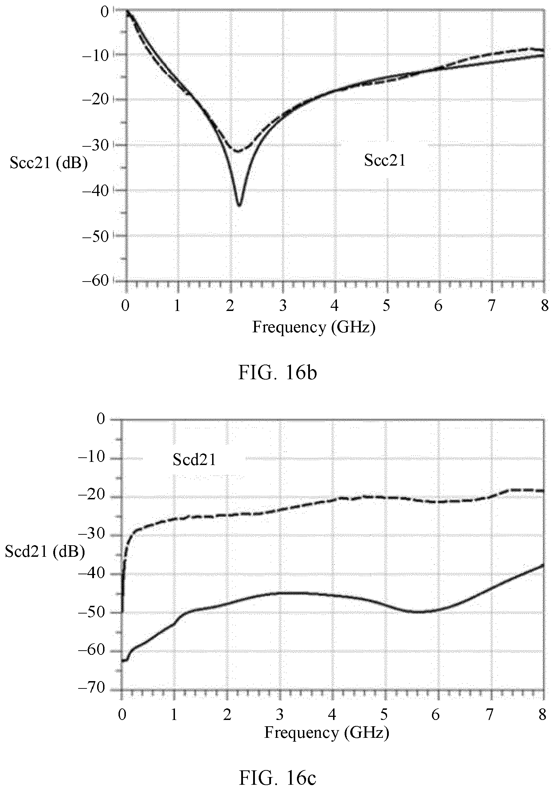

As shown in FIG. 16b, a black solid line is a curve of a common mode insertion loss Scc21 of the common mode filter, and a dashed line is a curve of a common mode insertion loss Scc21 in the conventional technology. It can be seen from the two curves that a center frequency of Scc21 is moved to about 2 GHz, and when Scc21 is smaller than -15 dB, a corresponding common mode suppression bandwidth may cover 900 MHz to 5 GHz. Therefore, performance of the common mode filter meets the 5G communication frequency band and the global system for mobile communications (Global System for Mobile Communications, GSM) standards, and satisfies 5G high-speed high-frequency scenarios with a transmission rate lower than 10 Gbps.

As shown in FIG. 16c, a black solid line is a curve of a mode conversion loss Scd21 of the common mode filter, and a dashed line is a curve of a mode conversion loss Scd21 in the conventional technology. It can be seen from the two curves that the mode conversion loss of the common mode filter is obviously preferred over that in the conventional technology.

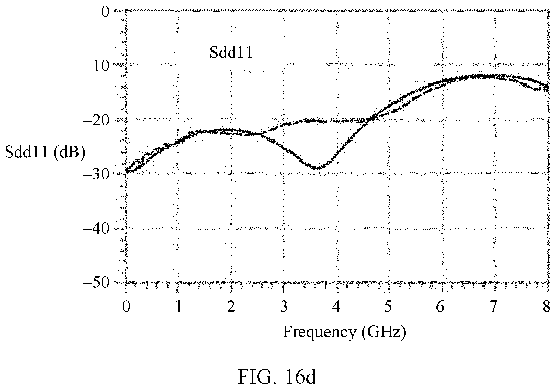

As shown in FIG. 16d, a black solid line is a curve of a return loss Sdd11 of the common mode filter, and a dashed line is a curve of a return loss Sdd11 in the conventional technology. The return loss of the common mode filter is preferred over that in the conventional technology.

The structure shown in FIG. 15 may be manufactured by using a magnetic device thin film process. The following describes in detail a method for manufacturing a two-wire common mode filter by using the magnetic device thin film process.

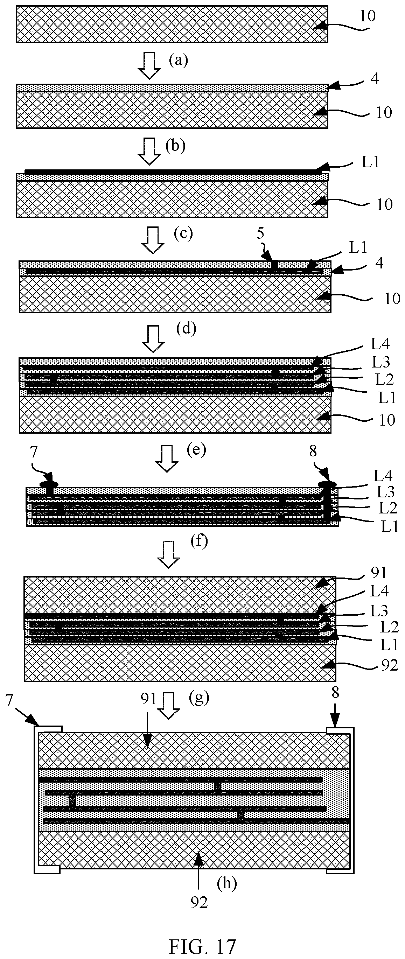

As shown in FIG. 17, the method for manufacturing a common mode filter includes the following steps:

As shown in (a) and (b) in FIG. 17, a dielectric layer 4 is formed on a surface of a support plate 10.

As shown in (c) in FIG. 17, a first winding and a second winding are set on the dielectric layer 4, so that the first winding and the second winding are disposed on the dielectric layer 4, and the first winding and the second winding form a spiral first coil layer L1 that rotates around a same axis. At the first coil layer L1, from an inner turn to an outer turn, the first winding is located at the inner turn relative to the second winding.

In addition, when the first coil layer L1 is formed, the first winding and the second winding are disposed in a manner of surrounding counterclockwise from outside to inside.

As shown in (d) in FIG. 17, another dielectric layer 4 is formed above the first coil layer L1, and a conductive channel 5 is formed at the another dielectric layer 4.

According to the method in (b), (c), and (d) in FIG. 17, as shown in (e) in FIG. 17, a second coil layer L2, a third coil layer L3, and a fourth coil layer L4 are sequentially formed.

At the second coil layer L2, from an inner turn to an outer turn, the second winding is located at the inner turn relative to the first winding.

At the third coil layer L3, from an inner turn to an outer turn, the first winding is located at the inner turn relative to the second winding.

At the fourth coil layer L4, from an inner turn to an outer turn, the second winding is located at the inner turn relative to the first winding.

When the second coil layer L2 is formed, the first winding and the second winding are disposed in a manner of surrounding counterclockwise from inside to outside.

When the third coil layer L3 is formed, the first winding and the second winding are disposed in a manner of surrounding counterclockwise from outside to inside.

When the fourth coil layer L4 is formed, the first winding and the second winding are disposed in a manner of surrounding counterclockwise from inside to outside.

As shown in (f) in FIG. 17, the support plate 10 is removed.

As shown in (g) in FIG. 17, a first substrate 91 and a second substrate 92 are disposed, so that the four coil layers are loaded between the first substrate 91 and the second substrate 92.

As shown in (h) in FIG. 17, an inlet terminal 7 and an outlet terminal 8 are respectively disposed on a side face including the first substrate 91, the second substrate 92, and the four coil layers.

In addition, when the two-wire common mode filter is manufactured according to FIG. 17, after a plurality of coil layers are formed, and before the inlet terminal and the outlet terminal are disposed, the method further includes: cutting the common mode filter along a direction parallel to a stacking direction, and then disposing the inlet terminal and the outlet terminal.

The foregoing provides the method for manufacturing a two-wire common mode filter having four coil layers. If there are more coil layers, a two-wire common mode filter may be manufactured by analogy according to the foregoing method, and details are not described herein again.

The following describes a structure of a three-wire common mode filter in detail.

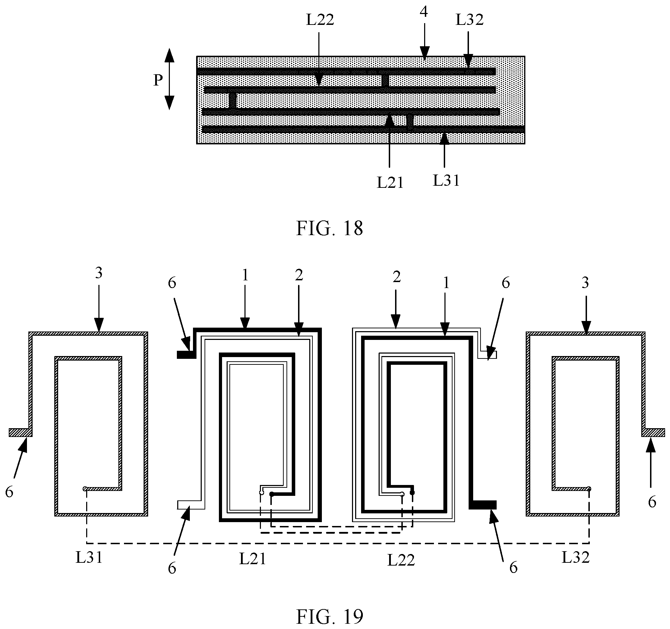

FIG. 18 is a sectional view of a three-wire common mode filter, and FIG. 19 shows a wiring structure of each coil layer in FIG. 18. The common mode filter includes a two-wire coil layer and a single-wire coil layer.

As shown in FIG. 18, the two-wire coil layer in the three-wire common mode filter provided in this application includes two layers: a first two-wire coil layer L21 and a second two-wire coil layer L22. The single-wire coil layer includes two layers: a first single-wire coil layer L31 and a second single-wire coil layer L32.

In this way, because the two-wire coil layer includes a first winding and a second winding, the formed three-wire common mode filter has four coil layers. Compared with conventional six coil layers, a quantity of wiring layers is reduced, thereby reducing a thickness of the entire three-wire common mode filter in a stacking direction and implementing a compact design of the three-wire common mode filter.

Certainly, in some implementations, there may be more than two two-wire coil layers, and there may also be more than two single-wire coil layers.

Refer to FIG. 19. A portion of the first winding 1 and a portion of the second winding 2 are formed, by rotating around a same axis, at a two-wire coil layer. The other portion of the first winding 1 and the other portion of the second winding 2 are formed, by rotating around another same axis, at another two-wire coil layer. A portion of a third winding 3 is formed at a single-wire coil layer, and the other portion of the third winding 3 is formed at another single-wire coil layer.

The first winding 1 at the first two-wire coil layer L21 is electrically connected (as shown by a dashed line in FIG. 19) to the first winding 1 at the second two-wire coil layer L22, and the second winding 2 at the first two-wire coil layer L21 is electrically connected (as shown by a dashed line in FIG. 19) to the second winding 2 at the second two-wire coil layer L22, to implement an electrical connection between the first two-wire coil layer L21 and the second two-wire coil layer L22.

The third winding 3 at the first single-wire coil layer L31 is electrically connected (as shown by a dashed line in Figure 19) to the third winding 3 at the second single-wire coil layer L32, to implement an electrical connection between the first single-wire coil layer L31 and the second single-wire coil layer L32.

Further, as shown in FIG. 19, at the first two-wire coil layer L21 and the second two-wire coil layer L22, there is one turn of the second winding 2 between each two adjacent turns of the first winding 1.

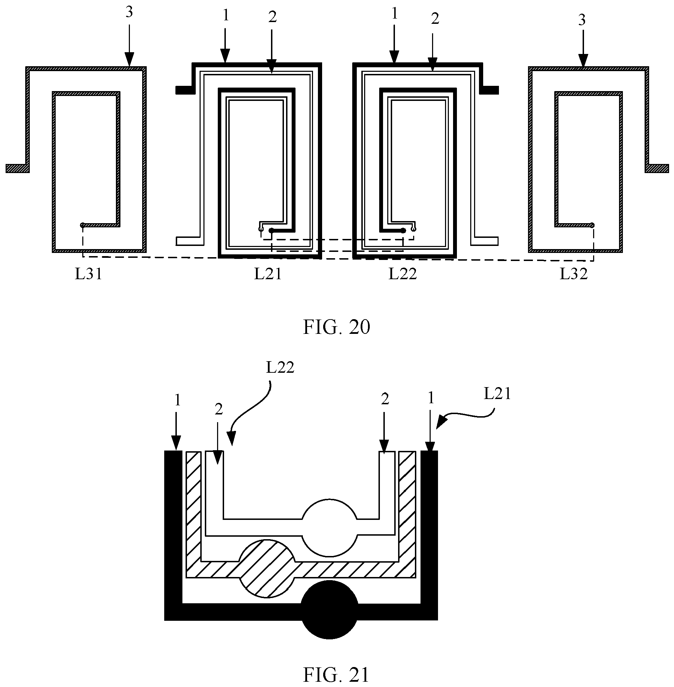

FIG. 20 shows another wiring structure of each coil layer in FIG. 18. The difference between FIG. 20 and FIG. 19 lies in that at the first two-wire coil layer L21 in FIG. 19, the first winding and the second winding are disposed in a manner of surrounding from an outer turn to an inner turn, and the second winding is located at the outer turn relative to the first winding. At the second two-wire coil layer L22, the first winding and the second winding are disposed in a manner of surrounding from an inner turn to an outer turn, and the second winding is located at the inner turn relative to the first winding. At the first two-wire coil layer L21 shown in FIG. 20, the first winding and the second winding are disposed in a manner of surrounding from an outer turn to an inner turn, and the second winding is located at the inner turn relative to the first winding. At the second two-wire coil layer L22, the first winding and the second winding are disposed in a manner of surrounding from an inner turn to an outer turn, the second winding is still located at the inner turn relative to the first winding.

In the structure shown in FIG. 19 compared with that shown in FIG. 20, when a quantity of turns at the first two-wire coil layer L21 is the same as a quantity of turns at the second two-wire coil layer L22, a sum of lengths of the first winding 1 at the two two-wire coil layers is basically equal to a sum of lengths of the second winding 2. After a differential signal is transmitted through the first two-wire coil layer L21 and the second two-wire coil layer L22, a latency difference of signal transmission is eliminated, and no conversion from a differential mode signal to a common mode signal is caused, thereby reducing Scd21 and improving balance of the common mode filter.

When the first two-wire coil layer L21 and the second two-wire coil layer L22 are routed in the manner shown in FIG. 19, the connection structure shown in FIG. 4 and FIG. 5 may be configured to connect the first winding and the second winding. To be specific, a portion that is of the second winding 2 at the first two-wire coil layer L21 and that is close to the conductive channel intersects, on an orthogonal plane of the stacking direction, with a portion that is of the first winding 1 at the second two-wire coil layer L22 and that is close to the conductive channel.

When the first two-wire coil layer L21 and the second two-wire coil layer L22 are routed in the manner shown in FIG. 20, because the first winding and the second winding are not exchanged between the two two-wire coil layers, the inter-layer cross structure shown in FIG. 4 and FIG. 5 are not required to be electrically connected to the windings. A connection structure shown in FIG. 21 may be used. To be specific, a portion that is of the second winding 2 at the first two-wire coil layer L21 and that is close to the conductive channel does not intersect, on an orthogonal plane of the stacking direction, with a portion that is of the first winding 1 at the second two-wire coil layer L22 and that is close to the conductive channel.

It should be noted that a structure of a spiral approximating a rectangle formed at each coil layer in FIG. 19 and FIG. 20 is merely an embodiment, and may alternatively be an elliptic spiral, a circular spiral, or the like.

Refer to FIG. 19 and FIG. 20. The first winding and the second winding each have a connection end 6 extending to an outside of the spiral, and the third winding also has a connection end 6 extending to an outside of the spiral. The connection end 6 is configured to connect to an inlet terminal or an outlet terminal. Refer to FIG. 19, at the first two-wire coil layer L21 and the second two-wire coil layer L2, connection ends 6 are farther away from each other. A difference in spiral windings is that the first winding and the second winding are disposed in a manner of surrounding in parallel around an axis. In this way, there is a high impedance between two connection ends. Refer to FIG. 19. To reduce the impedance, mitigate a sudden impedance change caused by no coupling, and reduce a return loss, the connection ends may be widened, that is, a wire width of the connection end 6 is greater than a wire width of the spiral winding. Similarly, widths of the connection ends at the first single-wire coil layer L31 and the second single-wire coil layer L32 may also be greater.

The two two-wire coil layers and the two single-wire coil layers have a plurality of stacking manners.

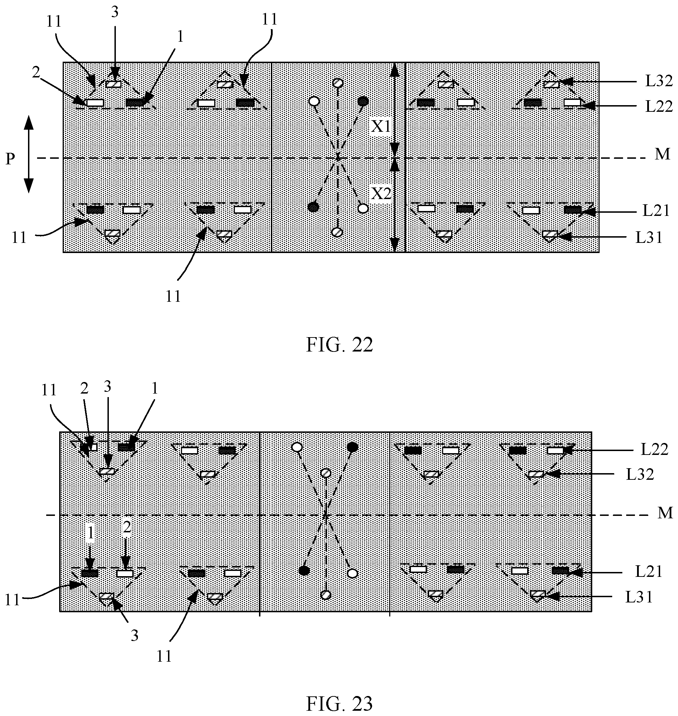

FIG. 22 shows a stacking manner. A first single-wire coil layer L31, a first two-wire coil layer L21, a second two-wire coil layer L22, and a second single-wire coil layer L32 are sequentially stacked.

FIG. 23 shows another stacking manner. A first single-wire coil layer L31, a first two-wire coil layer L21, a second single-wire coil layer L32, and a second two-wire coil layer L22 are sequentially stacked.

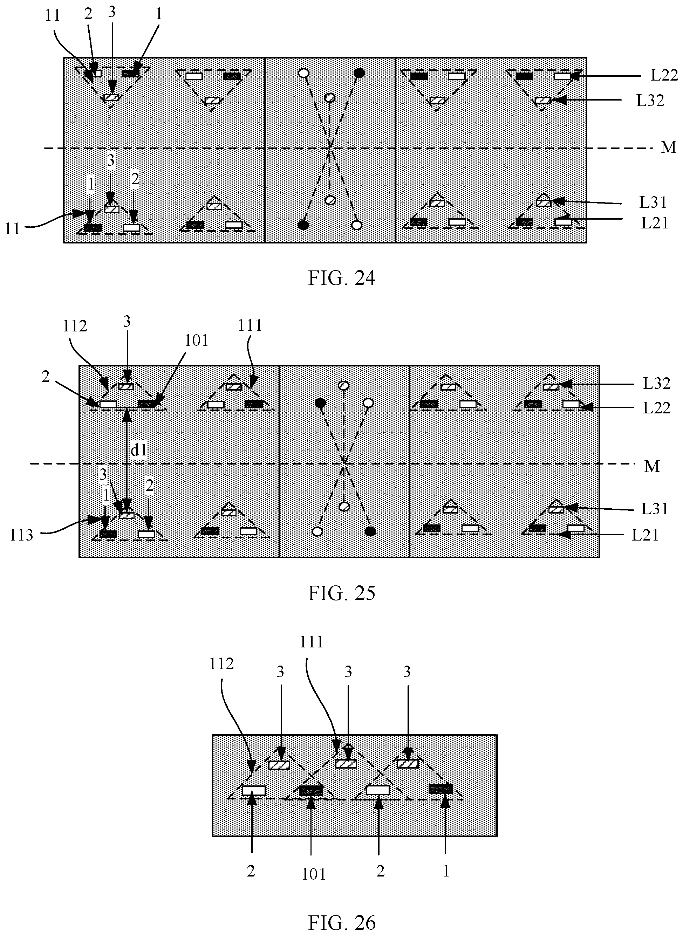

FIG. 24 shows another stacking manner. A first two-wire coil layer L21, a first single-wire coil layer L31, a second single-wire coil layer L32, and a second two-wire coil layer L22 are sequentially stacked.

FIG. 25 shows another stacking manner. A first two-wire coil layer L21, a first single-wire coil layer L31, a second two-wire coil layer L22, and a second single-wire coil layer L32 are sequentially stacked.

As shown in FIG. 22 to FIG. 25, between a two-wire coil layer and a single-wire coil layer that are adjacent to each other, in an orthogonal direction of a stacking direction, a third winding 3, a first winding 1, and a second winding 2 are staggered, and form a plurality of triangular coupling structures 11 independent of each other, and any turn of the first winding 1 or any turn of the second winding 2 belongs to an independent triangular coupling structure 11.

It can be understood that any turn of the first winding 1 or any turn of the second winding 2 belongs to an independent triangular coupling structure 11. For example, as shown in FIG. 25, a first turn 101 of the first winding belongs to only a second triangular coupling structure 112.

FIG. 26 is a sectional view of a three-wire common mode filter in the conventional technology. It can be seen from FIG. 26 that a first turn 101 of a first winding belongs to a first triangular coupling structure 111 and a second triangular coupling structure 112.

Compared with the conventional three-wire common mode filter shown in FIG. 26, in the three-wire common mode filter provided in this embodiment of this application in FIG. 25, a plurality of triangular coupling structures independent of each other are formed. In this way, it can be ensured that impedances and coupling inductances of three wires are basically consistent, and are not affected by three wires in another triangular coupling structure, thereby reducing a mode conversion loss of a signal and improving balance. In addition, the three-wire common mode filter with a four-layer wiring structure has a lower parasitic capacitance and a higher suppression bandwidth.

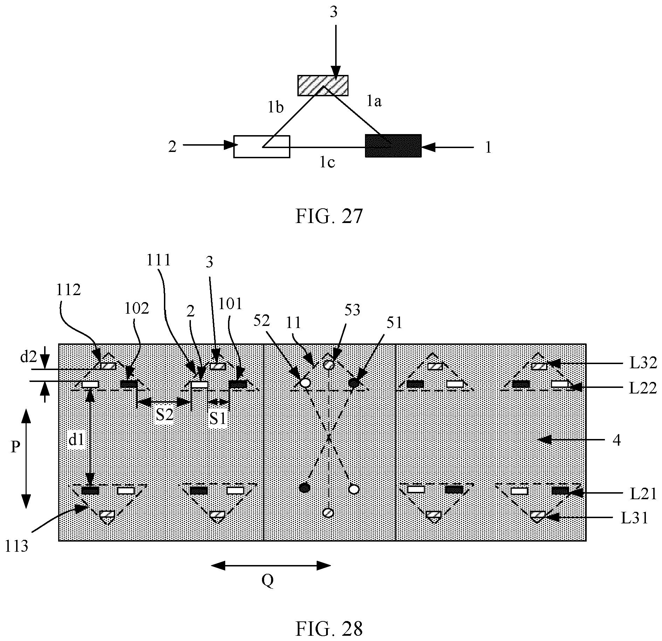

FIG. 27 shows a triangular coupling structure according to this application. In a specific implementation, a spacing 1a between a third winding 3 and a first winding 1, a spacing 1b between the third winding 3 and a second winding 2, and a spacing 1c between the second winding 2 and the first winding 1 do not necessarily form an equilateral triangle, provided that the three windings implement equal impedances and equal coupling.

As shown in FIG. 22 and FIG. 24, the first two-wire coil layer L21 and the second two-wire coil layer L22 are symmetrically disposed with respect to a middle plane M, and the first single-wire coil layer L31 and the second single-wire coil layer L32 are also symmetrically disposed with respect to the middle plane M.

As shown in FIG. 23 and FIG. 25, the first two-wire coil layer L21 and the second two-wire coil layer L22 are asymmetrically disposed with respect to a middle plane M, and the first single-wire coil layer L31 and the second single-wire coil layer L32 are asymmetrically disposed with respect to the middle plane M.

When the first two-wire coil layer L21, the first single-wire coil layer L31, the second two-wire coil layer L22, and the second single-wire coil layer L32 are symmetrically disposed with respect to the middle plane M shown in FIG. 22 and FIG. 24, the balance can be further improved.

It should be noted that, as shown in FIG. 22, the middle plane M herein is a plane orthogonal to the stacking direction P, and a distance X1 between the middle plane M and a first surface of the common mode filter is equal to or close to a distance X2 between the middle plane M and a second surface of the common mode filter.

Generally, as shown in FIG. 28, a first conductive channel 51, a second conductive channel 52, and a third conductive channel 53 pass through a dielectric layer 4.

A first winding at a first two-wire coil layer L21 is electrically connected to a first winding at a second two-wire coil layer L22 through the first conductive channel 51.

A second winding at a first two-wire coil layer L21 is electrically connected to a second winding at a second two-wire coil layer L22 through the second conductive channel 52.

A third winding at a first single-wire coil layer L31 is electrically connected to a third winding at a second single-wire coil layer L32 through the third conductive channel 53.

Refer to FIG. 28. To further improve balance, in an orthogonal direction Q of a stacking direction P, the first conductive channel 51, the second conductive channel 52, and the third conductive channel 53 are not located on a same straight line, but as shown in FIG. 28, the first conductive channel 51, the second conductive channel 52, and the third conductive channel 53 are staggered, and form a triangular coupling structure 11.

To further improve the balance of the three-wire common mode filter, two adjacent triangular coupling structures are isolated and moved away from each other in a direction that intersects with the stacking direction. Refer to FIG. 28, at any two-wire coil layer, each two adjacent turns of the first winding are respectively a first turn 101 of the first winding and a second turn 102 of the first winding. A turn of the second winding located between the first turn 101 of the first winding and the second turn 102 of the first winding is an intermediate turn 2 of the second winding. A spacing S 1 between the intermediate turn 2 of the second winding and the first turn 101 of the first winding is smaller than a spacing S2 between the intermediate turn 2 of the second winding and the second turn 102 of the first winding. The third winding 3, the intermediate turn 2 of the second winding, and the first turn 101 of the first winding form an independent triangular coupling structure. In this way, a first triangular coupling structure 111 and a second triangular coupling structure 112 are moved far away from each other in the orthogonal direction (which may be referred to as a horizontal direction) of the stacking direction, thereby reducing a characteristic impedance fluctuation and a distributed capacitance, and improving an insertion loss Sdd21, a return loss Sdd11, and balance performance Scd21. In a design of S2 and S1, both a balance performance requirement and a length (a size along the Q direction in FIG. 28) requirement of the entire common mode filter need to be considered in the design of S2 and the design of S1.

Refer to FIG. 28. In addition, in the stacking direction P, a spacing between two adjacent triangular coupling structures is d1, and in each triangular coupling structure, a spacing between the two-wire coil layer and the single-wire coil layer that are adjacent to each other is d2, where d2 is greater than d1. In this way, in the stacking direction, the two adjacent triangular coupling structures are moved away and isolated from each other, the characteristic impedance fluctuation and the distributed capacitance are reduced, and the insertion loss Sdd21, the return loss Sdd11, and the balance performance Scd21 are improved. However, isolating and moving the two adjacent triangular coupling structures away from each other reduce a common mode inductance, and weaken a low-frequency interference suppression capability. Therefore, in a design of d1 and d2, both a balance performance requirement and a height requirement for the entire common mode filter need to be considered in the design of d1 and the design of d2.

It should be noted that the spacing d1 between the two adjacent triangular coupling structures herein indicates that, for example, as shown in FIG. 25, because the first single-wire coil layer L31 is adjacent to the second two-wire coil layer L22 between the second triangular coupling structure 112 and the third triangular coupling structure 113 that are adjacent, a spacing d1 between the second triangular coupling structure 112 and the third triangular coupling structure 113 that are adjacent is a spacing between the first single-wire coil layer L31 and the second two-wire coil layer L22. For another example, as shown in FIG. 28, because the first two-wire coil layer L21 is adjacent to the second two-wire coil layer L22 between the second triangular coupling structure 112 and the third triangular coupling structure 113 that are adjacent, a spacing d1 between the second triangular coupling structure 112 and the third triangular coupling structure 113 that are adjacent is a spacing between the first two-wire coil layer L21 and the second two-wire coil layer L22.

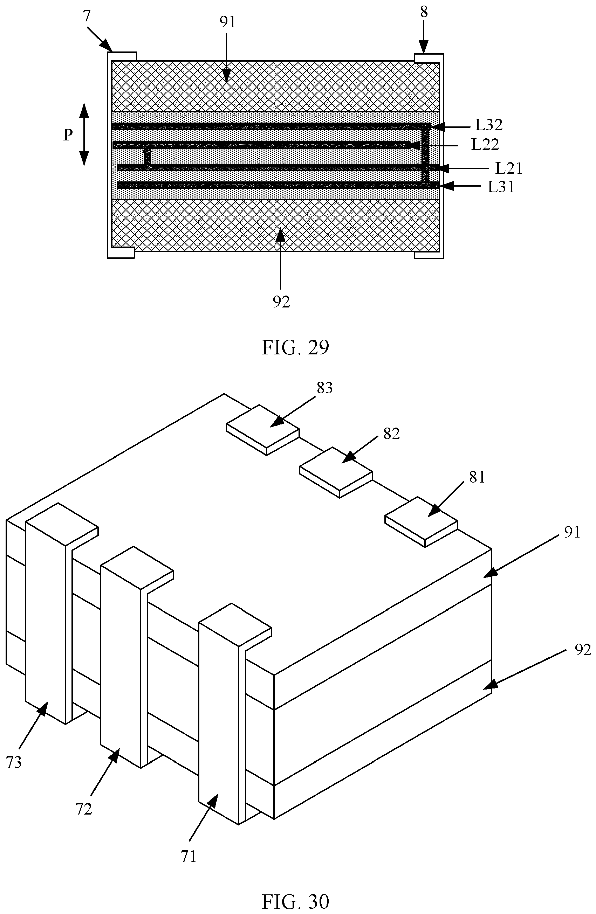

FIG. 29 and FIG. 30 show a three-wire common mode filter including a substrate. The three-wire common mode filter includes a first substrate 91 and a second substrate 92. The first substrate 91 and the second substrate 92 are disposed opposite to each other, and a plurality of coil layers are stacked between the first substrate 91 and the second substrate 92 along a stacking direction P. An inlet terminal 7 and an outlet terminal 8 are located on two sides of the common mode filter.

The inlet terminal 7 includes a first inlet terminal 71, a second inlet terminal 72, and a third inlet terminal 73. The first inlet terminal 71 is electrically connected to a first winding at a first two-wire coil layer, the second inlet terminal 72 is electrically connected to a second winding at a first two-wire coil layer, and the third inlet terminal 73 is electrically connected to a third winding at a first single-wire coil layer.

The outlet terminal 8 includes a first outlet terminal 81, a second outlet terminal 82, and a third outlet terminal 83. The first outlet terminal 81 is electrically connected to a first winding at a second two-wire coil layer, the second outlet terminal 82 is electrically connected to a second winding at a second two-wire coil layer, and the third outlet terminal 83 is electrically connected to a third winding at a second single-wire coil layer.

In the three-wire common mode filter shown in FIG. 28 and FIG. 29, the first substrate 91 and the second substrate 92 each are made of a non-magnetic material. Alternatively, one of the first substrate 91 and the second substrate 92 is made of a non-magnetic material. Alternatively, the first substrate 91 and the second substrate 92 each are made of a magnetic material.

When at least one of the first substrate 91 and the second substrate 92 is made of a magnetic material, common mode magnetic field coupling between the windings is enhanced, a common mode inductance is improved, and a common mode suppression frequency is mainly about 3.3 GHz, meets a main frequency band of 5G RF interference, and is suitable for an application scenario of a camera C-PHY high-speed interface in a current 5G mobile phone.

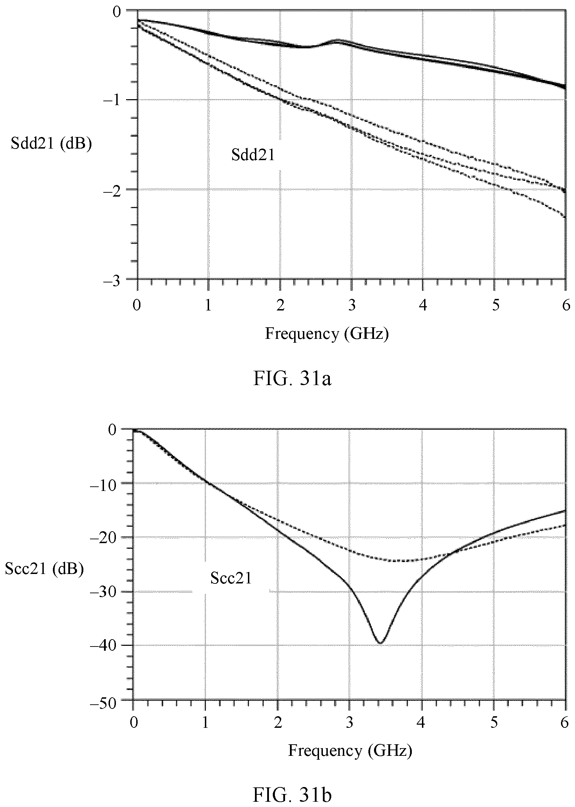

When at least one of the two substrates in the structure in FIG. 29 and FIG. 30 is a magnetic substrate, FIG. 31a to FIG. 31d are performance simulation of the three-wire common mode filter.

As shown in FIG. 31a, a black solid line is a curve of a differential mode insertion loss Sdd21 of the three-wire common mode filter, and a dashed line is a curve of a differential mode insertion loss Sdd21 in the conventional technology. It can be seen from the two curves that the differential mode insertion loss Sdd21 of the three-wire common mode filter is obviously reduced.

As shown in FIG 31b, a black solid line is a curve of a common mode insertion loss Scc21 of the three-wire common mode filter, and a dashed line is a curve of a common mode insertion loss Scc21 in the conventional technology. It can be seen from the two curves that the three-wire common mode filter has a lower parasitic capacitance and a higher suppression bandwidth.

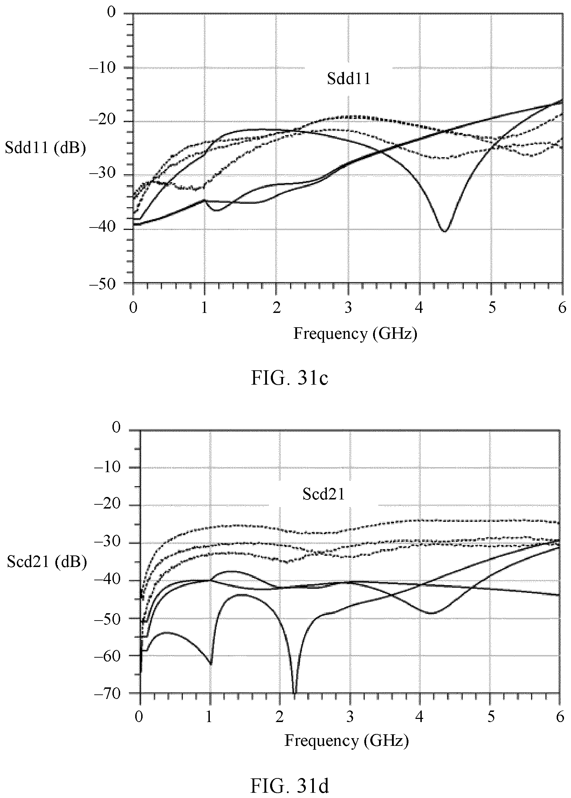

As shown in FIG. 31c, a black solid line is a curve of a mode conversion loss Scd21 of the common mode filter, and a dashed line is a curve of a mode conversion loss Scd21 in the conventional technology. It can be seen from the two curves that the three-wire common mode filter reduces a mode conversion loss of a signal.

As shown in FIG. 31d, a black solid line is a curve of a return loss Sdd11 of the common mode filter, and a dashed line is a curve of a return loss Sdd11 in the conventional technology. An insertion loss difference of the three-wire common mode filter is smaller, and impedance consistency of three wires is higher.

The structure shown in FIG. 29 and FIG. 30 may be manufactured by using a magnetic device thin film process. The following describes in detail a method for manufacturing a common mode filter by using the magnetic device thin film process.

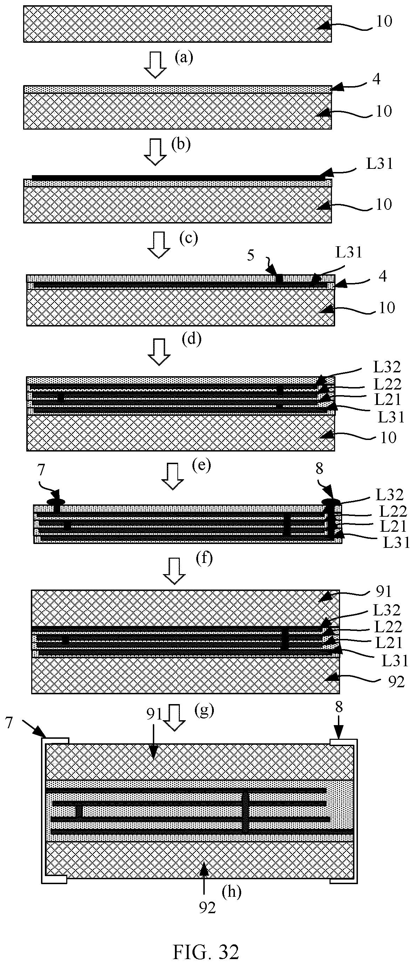

As shown in FIG. 32, the method for manufacturing a three-wire common mode filter includes the following steps:
As shown in (a) and (b) in FIG. 32, a dielectric layer 4 is formed on a surface of a support plate 10.

As shown in (c) in FIG. 32, a third winding is disposed at the dielectric layer 4, and the third winding rotates around an axis to form a spiral first single-wire coil layer L31.

When the first single-wire coil layer L31 is formed, the third winding is disposed in a manner of surrounding counterclockwise from outside to inside.

As shown in (d) in FIG. 32, another dielectric layer 4 is formed above the first single-wire coil layer L31, and a conductive channel 5 is formed at the another dielectric layer 4.

According to the method in (b), (c), and (d) in FIG. 32, as shown in (e) in FIG. 32, a first two-wire coil layer L21, a second two-wire coil layer L22, a second single-wire coil layer L32 are sequentially formed.

At the first two-wire coil layer L21, from an inner turn to an outer turn, a second winding is located at the inner turn relative to a first winding.

At the second two-wire coil layer L22, from an inner turn to an outer turn, a first winding is located at the inner turn relative to a second winding.

When the first two-wire coil layer L21 is formed, the first winding and the second winding are disposed in a manner of surrounding counterclockwise from outside to inside.

When the second two-wire coil layer L22 is formed, the first winding and the second winding are disposed in a manner of surrounding counterclockwise from inside to outside.

When the second single-wire coil layer L32 is formed, the third winding is disposed in a manner of surrounding counterclockwise from inside to outside.

As shown in (f) in FIG. 32, the support plate 10 is removed.

As shown in (g) in FIG. 32, a first substrate 91 and a second substrate 92 are disposed, so that the four coil layers are loaded between the first substrate 91 and the second substrate 92.

As shown in (h) in FIG. 32, an inlet terminal 7 and an outlet terminal 8 are disposed.

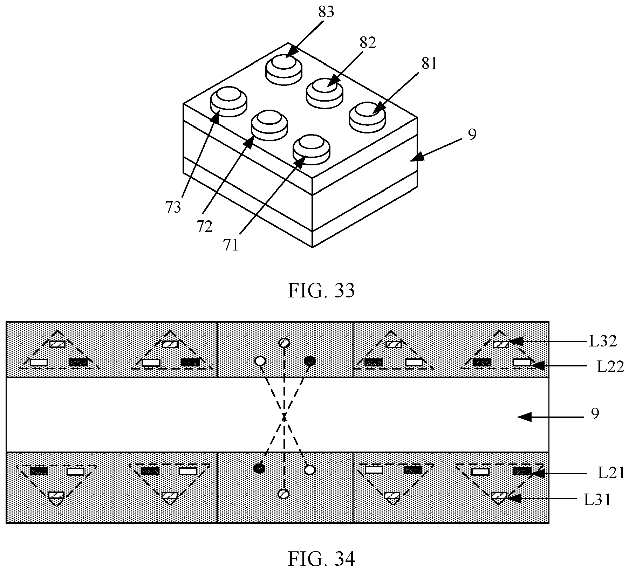

FIG. 33 and FIG. 34 show another three-wire common mode filter including a substrate. The three-wire common mode filter includes a substrate 9. The substrate 9 has a first surface and a second surface that are opposite to each other. A first two-wire coil layer 21 and a first single-wire coil layer 31 are disposed on the first surface, and a second two-wire coil layer 22 and a second single-wire coil layer 32 are disposed on the second surface. In this way, triangular coupling structures that are consistent with a stacking direction can be moved away and isolated from each other by using the substrate 9.

In the structures in FIG. 33 and FIG. 34, a conductive channel passes through the substrate 9, to implement an electrical connection between the first two-wire coil layer 21 and the second two-wire coil layer 22, and further implement an electrical connection between the first single-wire coil layer 31 and the second single-wire coil layer 32.

The substrate in FIG. 33 and FIG. 34 may be made of a magnetic material, or may be made of a non-magnetic material, for example, ferrite, resin, ceramic, silicon, or glass. When the substrate is made of silicon, the conductive channel formed in the substrate is a through silicon via (Through Silicon Via, TSV). When the substrate is made of glass, the conductive channel formed in the substrate is a through glass via (Through Glass Via, TGV).

When the substrate of the three-wire common mode filter in FIG. 33 and FIG. 34 is not made of any magnetic material, no height is reduced, thereby further increasing an isolation distance between an upper coil layer and a lower coil layer. Therefore, the three-wire common mode filter has superior high-frequency performance, and a common-mode suppression resonance frequency is above 8 GHz, so that the three-wire common mode filter is more suitable for future millimeter-band communication and an application scenario of a C-PHY ultra-high-speed rate.

When the substrate 9 in the structure in FIG. 33 and FIG. 34 is a non-magnetic substrate, the three-wire common mode filter may be manufactured by using a conventional semiconductor process. The following describes in detail a method for manufacturing a three-wire common mode filter by using the semiconductor process.

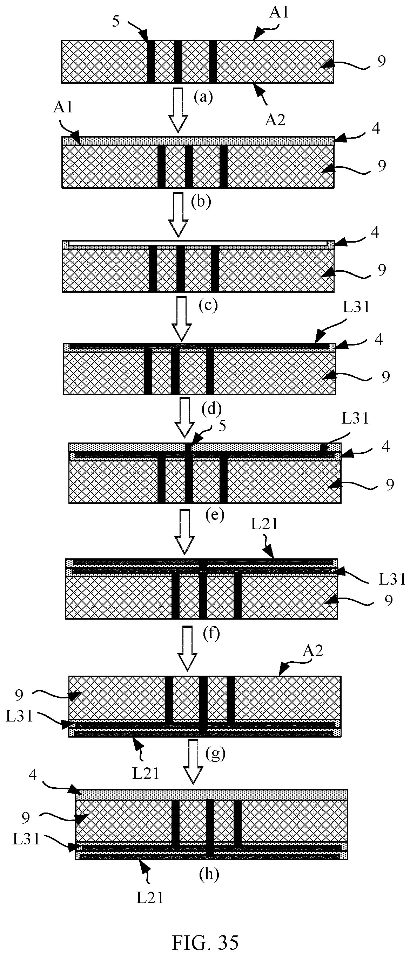

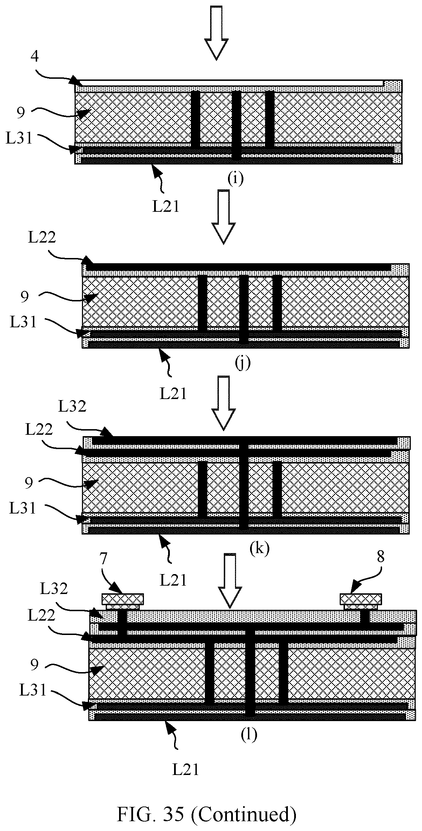

As shown in FIG. 35, the method for manufacturing a three-wire common mode filter includes the following steps:
As shown in (a) in FIG. 35, a conductive channel 5 is formed in a substrate 9 made of a non-magnetic material, and the conductive channel passes through a first surface A1 to a second surface A2.

As shown in (b) in FIG. 35, a dielectric layer 4 is formed on the first surface A1.

As shown in (c) in FIG. 35, the dielectric layer 4 is patterned, to form a pattern layer on the substrate 9.

As shown in (d) in FIG. 35, a third winding is disposed on the substrate formed with the pattern layer, and the third winding rotates around an axis to form a spiral first single-wire coil layer L31.

When the first single-wire coil layer L31 is formed, the third winding is disposed in a manner of surrounding counterclockwise from outside to inside.

As shown in (e) in FIG. 35, another dielectric layer 4 is formed above the first single-wire coil layer L31, and a conductive channel 5 is formed at the another dielectric layer 4.

According to (b), (c), and (d) in FIG. 35, as shown in (f) in FIG. 35, a first two-wire coil layer L21 is formed.

At the first two-wire coil layer L21, from an inner turn to an outer turn, a second winding is located at the inner turn relative to a first winding.

When the first two-wire coil layer L21 is formed, the first winding and the second winding are disposed in a manner of surrounding counterclockwise from outside to inside.

As shown in (g) in FIG. 35, the substrate 9 with the first two-wire coil layer L21 and the first single-wire coil layer L31 are disposed in an inverted manner, so that the second surface A2 of the substrate is upward.

As shown in (h) in FIG. 35, a dielectric layer 4 is formed on the second surface A2.

As shown in (i) in FIG. 35, the dielectric layer 4 is patterned, to form a pattern layer on the substrate 9.

As shown in (j) in FIG. 35, a first winding and a second winding are disposed on the substrate formed with the pattern layer, and the first winding and the second winding rotate around a same axis to form a spiral second two-wire coil layer L22.

At the second two-wire coil layer L22, from an inner turn to an outer turn, a first winding is located at the inner turn relative to a second winding.

When the second two-wire coil layer L22 is formed, the first winding and the second winding are disposed in a manner of surrounding counterclockwise from inside to outside.

As shown in (k) in FIG. 35, another dielectric layer 4 is formed above the second two-wire coil layer L22, and a conductive channel 5 is formed at the another dielectric layer 4. The dielectric layer 4 is patterned, to form a pattern layer on the substrate 9. A third winding is disposed at the pattern layer to form a second single-wire coil layer L32.

When the second single-wire coil layer L32 is formed, the third winding is disposed in a manner of surrounding counterclockwise from inside to outside.

As shown in (l) in FIG. 35, an inlet terminal 7 and an outlet terminal 8 are disposed.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A common mode filter, comprising:
a first winding; and
a second winding, wherein
a portion of the first winding and a portion of the second winding are formed, by rotating around a same axis, at a first coil layer, the other portion of the first winding and the other portion of the second winding are formed, by rotating around another same axis, at a second coil layer stacked with the first coil layer, and at the first coil layer and the second coil layer, there is one turn of the second winding between each two adjacent turns of the first winding;
at the first coil layer, the first winding and the second winding are disposed in a manner of surrounding from an outer turn to an inner turn, and the second winding is located at the outer turn relative to the first winding;
at the second coil layer, the first winding and the second winding are disposed in a manner of surrounding from an inner turn to an outer turn, and the second winding is located at the inner turn relative to the first winding; and
a surrounding direction of the first winding and the second winding at the second coil layer is the same as a surrounding direction of the first winding and the second winding at the first coil layer.

2. The common mode filter according to claim 1, wherein the first winding and the second winding are staggered in an orthogonal direction of a stacking direction of the first coil layer and the second coil layer.

3. The common mode filter according to claim 1 or 2, wherein at any one of the first coil layer and the second coil layer, each two adjacent turns of the first winding are respectively a first turn of the first winding and a second turn of the first winding, a turn of the second winding located between the first turn of the first winding and the second turn of the first winding is an intermediate turn of the second winding, and a spacing between the intermediate turn of the second winding and the first turn of the first winding is smaller than a spacing between the intermediate turn of the second winding and the second turn of the first winding.

4. The common mode filter according to any one of claims 1 to 3, wherein the first coil layer and the second coil layer are disposed in a dielectric layer, and are spaced by the dielectric layer, a conductive channel consistent with the stacking direction passes through the dielectric layer, the first winding at the first coil layer is electrically connected to the first winding at the second coil layer through the conductive channel, and the second winding at the first coil layer is electrically connected to the second winding at the second coil layer through the conductive channel; and
a portion that is of the second winding at the first coil layer and that is close to the conductive channel intersects, in the orthogonal direction of the stacking direction, with a portion that is of the first winding at the second coil layer and that is close to the conductive channel.

5. The common mode filter according to any one of claims 1 to 4, wherein the first winding and the second winding each have a connection end extending to an outside of a spiral, the connection end is configured to connect to an inlet terminal or an outlet terminal, and a wire width of the connection end is greater than a wire width of the spiral winding.

6. The common mode filter according to any one of claims 1 to 5, wherein the common mode filter further comprises:
a substrate, wherein the second coil layer is disposed on a surface of the substrate, and the first coil layer is located at the second coil layer; and
the inlet terminal and the outlet terminal, both disposed on a side that is of the first coil layer and that is away from the second coil layer.

7. A common mode filter, comprising:
a first winding;
a second winding, wherein a portion of the first winding and a portion of the second winding are formed, by rotating around a same axis, at a two-wire coil layer, the other portion of the first winding and the other portion of the second winding are formed, by rotating around another same axis, at another two-wire coil layer, and at any one of the two-wire coil layers, there is one turn of the second winding between each two adjacent turns of the first winding; and
a third winding, wherein a portion of the third winding is formed at a single-wire coil layer, and the other portion of the third winding is formed at another single-wire coil layer, wherein
between the single-wire coil layer and the two-wire coil layers adjacent to the single-wire coil layer, in an orthogonal direction of a stacking direction, the third winding, the first winding, and the second winding are staggered, and form a plurality of triangular coupling structures independent of each other, and any turn of the first winding or any turn of the second winding belongs to an independent triangular coupling structure.

8. The common mode filter according to claim 7, wherein at any one of the two-wire coil layers, each two adjacent turns of the first winding are respectively a first turn of the first winding and a second turn of the first winding, a turn of the second winding located between the first turn of the first winding and the second turn of the first winding is an intermediate turn of the second winding, a spacing between the intermediate turn of the second winding and the first turn of the first winding is S 1, a spacing between the intermediate turn of the second winding and the second turn of the first winding is S2, and S1 is smaller than S2; and
the third winding, the intermediate turn of the second winding, and the first turn of the first winding form an independent triangular coupling structure.

9. The common mode filter according to claim 7 or 8, wherein in the stacking direction, a spacing between two adjacent triangular coupling structures is d1, in each triangular coupling structure, a spacing between the two-wire coil layer and the single-wire coil layer that are adjacent to each other is d2, and d2 is greater than d1.

10. The common mode filter according to any one of claims 7 to 9, wherein the two-wire coil layer and the single-wire coil layer are disposed in a dielectric layer, and are spaced by the dielectric layer, a first conductive channel, a second conductive channel, and a third conductive channel that are consistent with the stacking direction pass through the dielectric layer, first windings in two adjacent two-wire coil layers are electrically connected through the first conductive channel, second windings in the two adjacent two-wire coil layers are electrically connected through the second conductive channel, and third windings in the two adjacent single-wire coil layers are electrically connected through the third conductive channel; and
in the orthogonal direction of the stacking direction, the first conductive channel, the second conductive channel, and the third conductive channel are staggered, and form a triangular coupling structure.

11. The common mode filter according to any one of claims 7 to 10, wherein one of the two adjacent two-wire coil layers is a first two-wire coil layer, and the other is a second two-wire coil layer;
at the first coil layer, the first winding and the second winding are disposed in a manner of surrounding from an outer turn to an inner turn, and the second winding is located at the outer turn relative to the first winding; and
at the second coil layer, the first winding and the second winding are disposed in a manner of surrounding from an inner turn to an outer turn, the second winding is located at the inner turn relative to the first winding, a surrounding direction of the first winding and the second winding at the second coil layer is the same as a surrounding direction of the first winding and the second winding at the first coil layer.

12. The common mode filter according to claim 11, wherein a portion that is of the second winding at the first two-wire coil layer and that is close to the second conductive channel intersects, in the orthogonal direction of the stacking direction, with a portion that is of the first winding at the second two-wire coil layer and that is close to the first conductive channel.

13. The common mode filter according to any one of claims 7 to 12, wherein there are two single-wire coil layers: a first single-wire coil layer and a second single-wire coil layer, and there are two two-wire coil layers: the first two-wire coil layer and the second two-wire coil layer.

14. The common mode filter according to claim 13, wherein the common mode filter further comprises:
a substrate, wherein the substrate has a first surface and a second surface that are opposite to each other, and the substrate has a conductive channel that passes through from the first surface to the second surface; and
the first single-wire coil layer and the first two-wire coil layer are disposed on the first surface, and the second single-wire coil layer and the second two-wire coil layer are disposed on the second surface; and
an inlet terminal and an outlet terminal, respectively disposed on surfaces that are of the first single-wire coil layer and the first two-wire coil layer and that are away from the substrate.

15. A terminal device, comprising:
a printed circuit board; and
the common mode filter according to any one of claims 1 to 14, wherein
the common mode filter is electrically connected to the printed circuit board.
